(19) Europäisches Patentamt
European Patent Office
Office européen des brevets

(11) **EP 2 824 512 B1**

(12) **EUROPÄISCHE PATENTSCHRIFT**

(45) Veröffentlichungstag und Bekanntmachung des Hinweises auf die Patenterteilung:
**17.06.2020 Patentblatt 2020/25**

(51) Int Cl.:
***G03F 7/20*** *(2006.01)*

(21) Anmeldenummer: **14175389.7**

(22) Anmeldetag: **02.07.2014**

(54) **Beleuchtungsoptik für die Projektionslithografie**

Illumination lens for projection lithography

Optique d'éclairage pour lithographie de projection

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.07.2013 DE 102013213545**

(43) Veröffentlichungstag der Anmeldung:
**14.01.2015 Patentblatt 2015/03**

(73) Patentinhaber: **Carl Zeiss SMT GmbH 73447 Oberkochen (DE)**

(72) Erfinder:
• **Scholz, Axel**
  **73430 Aalen (DE)**
• **Patra, Michael**
  **73447 Oberkochen (DE)**
• **Schlesener, Frank**
  **73447 Oberkochen (DE)**
• **Maul, Manfred**
  **73434 Aalen (DE)**
• **Emer, Wolfgang**
  **73431 Aalen (DE)**
• **Hilt, Stefanie**
  **73433 Aalen (DE)**

(74) Vertreter: **Rau, Schneck & Hübner Patentanwälte Rechtsanwälte PartGmbB Königstraße 2 90402 Nürnberg (DE)**

(56) Entgegenhaltungen:
DE-A1-102004 063 314     DE-A1-102008 040 181
US-A1- 2004 021 845

## Beschreibung

Die Erfindung betrifft eine Beleuchtungsoptik für die Projektionslithografie zur Beleuchtung eines Beleuchtungsfeldes mit Beleuchtungslicht. Ferner betrifft die Erfindung ein optisches System mit einer derartigen Beleuchtungsoptik und eine Projektionsbelichtungsanlage mit einem derartigen optischen System. Weiterhin betrifft die Erfindung ein lithographisches Herstellungsverfahren für nano- bzw. mikrostrukturierte Bauelemente.

Ein Beleuchtungssystem der eingangs genannten Art ist bekannt aus der WO 2007/093433 A1, der WO 2005/083512 A2 und der WO 2011/157601 A2. Für anspruchsvolle Projektionsaufgaben ist es wünschenswert, die Beleuchtungslichteigenschaften über das Beleuchtungsfeld gezielt beeinflussen zu können. Dies ist mit dem gattungsgemäßen Beleuchtungssystem nicht bzw. nur mit hohem Aufwand möglich. Die DE 10 2008 040 181 A1 offenbart ein Beleuchtungssystem einer mikrolithographischen Projektionsbelichtungsanlage mit einem astigmatischen refraktiven optischen Element, mit dem sich eine Intensitätsverteilung in einer Pupillenfläche durch Anordnen an verschiedenen Positionen entlang einer optischen Achse astigmatisch verändern lässt. Die DE 10 2004 063 314 A1 offenbart eine Filtereinrichtung für die Kompensation einer asymmetrischen Pupillenausleuchtung, die innerhalb eines optischen Systems einer Projektionsbelichtungsanlage für die Mikrolithographie eingesetzt werden kann.

Es ist eine Aufgabe der vorliegenden Erfindung, eine Beleuchtungsoptik der eingangs genannten Art derart weiterzubilden, dass die Beleuchtungsintensität über das Beleuchtungsfeld beleuchtungswinkelabhängig gezielt beeinflusst werden kann.

Diese Aufgabe ist erfindungsgemäß gelöst durch eine Beleuchtungsoptik mit den im Anspruch 1 angegebenen Merkmalen. Die erfindungsgemäße Beleuchtungswinkel-Variationseinrichtung mit mindestens einer verlagerbaren Beleuchtungswinkel-Variationseinheit ermöglicht über eine Relativverlagerung der mindestens einen verlagerbaren Beleuchtungswinkel-Variationseinheit zur Rasteranordnung eine gezielte Beeinflussung einer gesamten Ablenkwirkung der Beleuchtungswinkel-Variationseinrichtung auf das Beleuchtungslicht. Je nach der Relativposition der verlagerbaren Beleuchtungswinkel-Variationseinheiten zur Rasteranordnung ergibt sich eine bestimmte Ablenkwirkung innerhalb eines Bereiches zwischen einem minimalen Ablenkwinkel in der Ablenkebene senkrecht zur Objektverlagerungsrichtung und einen maximalen Ablenkwinkel in dieser Ablenkebene. Dies kann zur gezielten Vorgabe einer ablenkenden Wirkung genutzt werden, sodass beispielsweise über die vorgegebene ablenkende Wirkung eine gezielte Vorgabe einer für die Projektionslithografie optimierten Beleuchtung möglich ist. Der Ablenkwinkel in der Ablenkebene, der durch die verlagerbare Beleuchtungswinkel-Variationseinheit herbeigeführt werden kann, beträgt maximal beispielsweise 3° bzw. 50 mrad. Eine Änderung des Ablenkwinkels um beispielsweise 30 mrad zwischen dem maximalen und dem minimalen Ablenkwinkel in der Ablenkebene kann durch die verlagerbare Beleuchtungswinkel-Variationseinheit herbeigeführt werden. Die Änderung des Ablenkwinkels kann beispielsweise so groß sein, dass durch die verlagerbare Beleuchtungswinkel-Variationseinheit eine ablenkende Wirkung einer anderen Einheit gerade kompensiert wird, so dass sich resultierend durch beide Einheiten gerade keine ablenkende Wirkung ergibt. Die Größe des maximal einstellbaren Ablenkwinkels kann vom maximalen Akzeptanzwinkel der Rasteranordnung abhängen. Dieser kann in der Ablenkebene einen anderen Wert haben als in einer hierzu senkrechten, die Objektverlagerungsrichtung enthaltenden Ebene. Die optisch wirkenden Flächen und insbesondere die Winkelvariationsabschnitte der Beleuchtungswinkel-Variationseinrichtung können als plane Flächen, können als sphärische Flächen, können als asphärische Flächen oder können als Freiformflächen gestaltet sein. Beispiele für optische Freiformflächengestaltungen finden sich in der US 7,414,781. Teil der Beleuchtungsoptik kann ein Mikrospiegelarray (multi-mirror array, MMA) sein, über dessen unabhängig voneinander verkippbare Einzelspiegel eine Beleuchtungslicht-Intensitätsverteilung auf der Rasteranordnung der Beleuchtungsoptik vorgegeben werden kann, die wiederum mit der Beleuchtungsoptik in eine Beleuchtungswinkelverteilung zur Beleuchtung des Beleuchtungsfeldes umgesetzt wird. Ein Beispiel für einen entsprechenden Einsatz eines Mikrospiegelarrays gibt die WO 2011/157601 A2. Die Ablenkung des Beleuchtungslichts in der Ablenkebene mit unterschiedlichen Ablenkwinkeln kann in mindestens zwei Winkelvariationsabschnitten der Beleuchtungswinkel-Variationseinrichtung erfolgen. Die Beleuchtungswinkel-Variationseinrichtung kann absolut unterschiedliche, statische Ablenkwinkel in mindestens zwei Winkelvariationsabschnitten erzeugen. Über die Beleuchtungswinkel-Variationseinrichtung kann ein kontinuierliches oder auch ein diskontinuierliches und insbesondere diskretes Spektrum an Ablenkwinkeln erzeugt werden.

Die Beleuchtungswinkel-Variationseinrichtung kann auch mindestens eine Beleuchtungswinkel-Variationseinheit mit mehr als zwei Winkelvariationsabschnitte aufweisen, in denen das Beleuchtungslicht in der Ablenkebene unterschiedlich abgelenkt wird. Eine ablenkende Wirkung kann sich abhängig vom Auftreffort des Beleuchtungslichts auf die Beleuchtungswinkel-Variationseinrichtung auch kontinuierlich ändern.

Die unterschiedlichen Ablenkwinkel, die in der Ablenkebene senkrecht zur Objektverlagerungsrichtung von der Beleuchtungswinkel-Variationseinrichtung hervorgerufen werden, können vom Absolutbetrag des Winkels her gleich sein und sich lediglich in ihrer Richtung unterscheiden, zum Beispiel $+\beta$, $-\beta$. Alternativ ist es möglich, Ablenkungen in verschiedene Ablenkrichtungen mit unterschiedlichen Winkel-Absolutbeträgen herbeizuführen, zum Beispiel $+\beta$, $-\beta/2$. Bei einer weiteren Variante der Beleuchtungswinkel-Variationseinrichtung können auch mehr als zwei unterschiedliche Ablenkwinkel herbeigeführt werden. Insbesondere kann ein Kontinuum unterschiedlicher Ablenkwinkel durch die Beleuchtungswinkel-Variationseinrichtung herbeigeführt werden.

Die Beleuchtungswinkel-Variationseinrichtung kann genau eine Beleuchtungswinkel-Variationseinheit aufweisen, nämlich die verlagerbare Beleuchtungswinkel-Variationseinheit.

Die Beleuchtungswinkel-Variationseinheit kann relativ zur Rasteranordnung translatorisch und/oder rotatorisch verlagerbar sein. Der Begriff "verlagerbar" schließt also eine Verlagerung in Bezug auf die sechs Freiheitsgrade der Translation und Rotation ein. Auch eine Verlagerung, bei der genau einer dieser Freiheitsgrade oder bei der mehr als einer dieser Freiheitsgrade, zum Beispiel zwei, drei, vier, fünf oder alle sechs Freiheitsgrade genutzt werden, ist möglich. Bei einem kartesischen Koordinatensystem, von dem zwei Koordinaten die Ablenkebene aufspannen und eine Koordinate durch die Objektverlagerungsrichtung vorgegeben ist, kann die Verlagerung demnach durch Translation in Richtung der ersten Koordinate (x) und/oder in Richtung der zweiten Koordinate (y) und/oder in Richtung der dritten Koordinate (z) und/oder durch Drehung um die erste Koordinate (x) und/oder durch Drehung um die zweite Koordinate (y) und/oder durch Drehung um die dritte Koordinate (z) herbeigeführt werden.

Bei einer Beleuchtungswinkel-Variationseinrichtung mit einer verlagerbaren Beleuchtungswinkel-Variationseinheit und einer weiteren Beleuchtungswinkel-Variationseinheit nach Anspruch 2 kann beispielsweise ein erster, konstanter Ablenkwinkel in der Ablenkebene senkrecht zur Objektverlagerungsrichtung fest voreingestellt werden. Dieser voreingestellte Ablenkwinkel kann dann mit der verlagerbaren Beleuchtungswinkel-Variationseinheit nach Bedarf moduliert werden. Das Beleuchtungslicht kann zuerst durch die verlagerbare Beleuchtungswinkel-Variationseinheit oder, bei einer alternativen Ausführung, auch zuerst durch die weitere Beleuchtungswinkel-Variationseinheit beeinflusst werden. Bei den beiden Beleuchtungswinkel-Variationseinheiten kann es sich um zwei Linsen mit zueinander veränderlichem Abstand handeln. Bei den zueinander verlagerbaren Beleuchtungswinkel-Variationseinheiten kann es sich auch um quer zu einem Strahlengang des Beleuchtungslichts verlagerbare Keil-Komponenten handeln.

Eine Ausführung nach Anspruch 3 ist mit vergleichsweise geringem konstruktivem Aufwand verbunden. Varianten für eine solche statische Beleuchtungswinkel-Variationseinheit sind beschrieben in der WO 2007/093433 A1. Alternativ ist es möglich, beide Beleuchtungswinkel-Variationseinheiten als verlagerbare Einheiten auszuführen. In Bezug auf den Begriff "Verlagerbarkeit" gilt, was vorstehend bereits erläutert wurde.

Eine Ausführung nach Anspruch 4 ermöglicht eine feine Vorgabe eines über den jeweiligen Ablenkwinkel variablen Beleuchtungsparameters.

Die Beleuchtungswinkel-Variationseinrichtung kann auch mehr als zwei Winkelvariationsabschnitte aufweisen, in der das Beleuchtungslicht in der Ablenkebene unterschiedlich abgelenkt wird. Eine ablenkende Wirkung kann sich abhängig vom Auftreffort des Beleuchtungslichts auf die Beleuchtungswinkel-Variationseinrichtung auch kontinuierlich ändern.

Eine relative ablenkende Wirkung nach Anspruch 5 ermöglicht eine feine Beeinflussung einer Gesamt-Ablenkwirkung über die verlagerbare Beleuchtungswinkel-Variationseinheit. Diese Beeinflussung kann in einer Abschwächung der Ablenkwirkung der weiteren Beleuchtungswinkel-Variationseinheit in der Ablenkebene und/oder in einer Verstärkung liegen. Es ist auch möglich, dass die verlagerbare Beleuchtungswinkel-Variationseinheit in einem Winkel-Variationsabschnitt die Ablenkwirkung der weiteren Beleuchtungswinkel-Variationseinheit schwächt in der Ablenkebene und in einem anderen Winkel-Variationsabschnitt die Ablenkwirkung der weiteren Beleuchtungswinkel-Variationseinheit in der Ablenkebene verstärkt. Alternativ ist es möglich, dass die maximale Ablenkwirkung der verlagerbaren Beleuchtungswinkel-Variationseinheit größer ist als eine maximale Ablenkwirkung der weiteren Beleuchtungswinkel-Variationseinheit. Alternativ kann die verlagerbare Beleuchtungswinkel-Variationseinheit die gleiche maximale Ablenkwirkung haben wie die weitere Beleuchtungswinkel-Variationseinheit. In einer Neutralstellung der beiden Beleuchtungswinkel-Variationseinheiten zueinander kann sich dann eine gegenseitige Kompensation der Ablenkwirkungen ergeben.

Eine Dachkantenprismen-Ausführung nach Anspruch 6 ist für eine Beleuchtungswinkel-Variationseinheit beschrieben in der WO 2007/093433 A1. Die als Dachkanten-Prisma ausgeführte mindestens eine Beleuchtungswinkel-Variationseinheit kann sich über eine gesamte Nutzapertur der Rasteranordnung erstrecken. Bei einer Zylinderlinsen-Ausführung ergibt sich eine kontinuierliche Änderung der Ablenkwirkung der mindestens einen als Zylinderlinse ausgeführten Beleuchtungswinkel-Variationseinheit. Auch die als Zylinderlinse ausgeführte mindestens eine Beleuchtungswinkel-Variationseinheit kann sich über die gesamte Nutzapertur der Rasteranordnung erstrecken. Die Sattelflächen-Komponente hat in Umfangsrichtung um ein Zentrum einen abwechselnden Verlauf zwischen einem sich zum Rand hin verjüngenden und einem sich zum Zentrum hin verjüngenden Keil-Verlauf, wobei der Wechsel in Umfangsrichtung z. B. jeweils alle 90° erfolgen kann.

Ein Keilkörper als Beleuchtungswinkel-Variationseinheit kann sich zur optischen Achse, also zum Strahlengang eines zentralen Einzelstrahls im Beleuchtungs-Strahlengang hin verjüngend oder nach außen hin verjüngend ausgeführt sein.

Soweit mehrere Beleuchtungswinkel-Variationseinheiten zum Einsatz kommen, können alle Beleuchtungswinkel-Variationseinheiten vom gleichen Typ sein, also beispielsweise als Dachkanten-Prismen und/oder als Zylinderlinsen ausgeführt sein. Eine Ausführung einer Beleuchtungswinkel-Variationseinrichtung ist möglich, bei der mindestens zwei Beleuchtungswinkel-Variationseinheiten als unterschiedliche Typen ausgeführt sind, beispielsweise eine Kombination eines Dachkanten-Prismas und einer Zylinderlinse. Alternativ oder zusätzlich kann eine der Beleuchtungswinkel-Variationseinrichtungen oder eine der Beleuchtungswinkel-Variationseinheiten als Alvarez-Manipulator ausgeführt sein, wie beispielsweise in der WO 2009/141033 A1 und in der EP 0 851 304 A beschrieben.

Die Beleuchtungswinkel-Variationseinrichtung kann im Strahlengang des Beleuchtungslichts vor der Rasteranordnung angeordnet sein. Es können dann insbesondere nichtlineare Einflüsse der Rasteranordnung auf einen Einfallswinkel des Beleuchtungslichts auf die Rasteranordnung gezielt durch eine entsprechende Auslegung der Beleuchtungswinkel-Variationseinrichtung ausgenutzt werden.

Die Beleuchtungswinkel-Variationseinrichtung kann alternativ oder zusätzlich in einer Feld-Zwischenebene angeordnet sein, die im Strahlengang des Beleuchtungslichts vor dem Beleuchtungsfeld liegt. Die Feld-Zwischenebene kann im Strahlengang des Beleuchtungslichts nach der Rasteranordnung angeordnet sein. Es ist also beispielsweise eine Anordnung der Beleuchtungswinkel-Variationseinrichtung möglich, bei der eine Beleuchtungswinkel-Variationseinheit im Strahlengang des Beleuchtungslichts vor der Rasteranordnung und eine andere Beleuchtungswinkel-Variationseinheit in einer Feld-Zwischenebene im Strahlengang des Beleuchtungslichts nach der Rasteranordnung angeordnet ist.

Die Beleuchtungswinkel-Variationseinrichtung kann zwei relativ zueinander senkrecht zum Strahlengang des Beleuchtungslichts verschiebbar angeordnete refraktive optische Platten mit jeweils mindestens einer gekrümmten Oberfläche aufweisen. Auch beide vom Beleuchtungslicht durchtretenen Oberflächen der Platten können gekrümmt ausgeführt sein.

Die beiden refraktiven optischen Platten der Beleuchtungswinkel-Variationseinrichtung können parallel zur Objektverlagerungsrichtung und/oder senkrecht zur Objektverlagerungsrichtung zueinander verschiebbar ausgeführt sein. Diese Verschiebung erfolgt jeweils senkrecht bzw. quer zum Strahlengang des Beleuchtungslichts.

Die beiden refraktiven optischen Platten können mit gekrümmten Oberflächen mit identischen Höhenprofilen ausgeführt sein.

Die beiden refraktiven optischen Platten der Beleuchtungswinkel-Variationseinrichtung können mit einander zugewandten, gekrümmten Oberflächen so ausgebildet sein, dass in genau einer Relativ-Verschiebeposition der beiden Platten zueinander ein einheitlich großer Luftspalt zwischen den beiden optischen Platten vorliegt.

Ein Höhenprofil der gekrümmten Oberflächen kann in der Ablenkebene senkrecht zur Objektverlagerungsrichtung einer Polynomfunktion folgen. Das Höhenprofil kann beispielsweise parabolisch sein. Alternativ kann das Höhenprofil der gekrümmten Oberfläche der refraktiven optischen Platte der Beleuchtungswinkel-Variationseinrichtung in der Ablenkebene senkrecht zur Objektverlagerungsrichtung einem Polynom dritter Ordnung folgen.

Das Höhenprofil der gekrümmten Oberfläche der refraktiven optischen Platte kann in der Ablenkebene senkrecht zur Objektverlagerungsrichtung wellenförmig ausgebildet sein und beispielsweise einer Kosinusfunktion folgen.

Ein Höhenprofil der gekrümmten Oberfläche der refraktiven optischen Platte kann in einer zur Ablenkebene senkrechten Ebene einen linearen oder konstanten Verlauf haben.

Die beiden refraktiven optischen Platten mit einander zugewandten, gekrümmten Oberflächen können so ausgebildet sein, dass in einer Relativ-Verschiebeposition der beiden Platten zueinander ein Luftspalt zwischen den beiden Platten in der Ablenkebene vorliegt, der in einem Zentrum eines Bündels des Beleuchtungslichts maximal ist und nach beiden Seiten hin zum Rand des Bündels monoton und insbesondere linear abfällt.

Die beiden refraktiven optischen Platten mit einander zugewandten, gekrümmten Oberflächen können so ausgebildet sein, dass in einer Relativ-Verschiebeposition der beiden Platten zueinander ein Luftspalt zwischen den beiden Platten senkrecht zur Ablenkebene vorliegt, der von einem Rand eines Bündels des Beleuchtungslichts hin zum anderen Rand des Bündels des Beleuchtungslichts monoton, streng monoton und insbesondere linear zu- oder abnimmt.

Allgemein ist ein Verlauf einer Dicke des Luftspaltes über die vom Bündel des Beleuchtungslichts genutzte Plattenfläche gegeben durch eine Differenz von Oberflächen-Topografien der den Luftspalt begrenzenden Platten-Oberflächen in einer Relativ-Verschiebeposition der beiden Platten. Die Spaltdicke d kann dabei geschrieben werden als:

$$d\,(x, y, a, b) = F_1\,(x, y) - F_2\,(x{+}a,\ y{+}b)$$

$F_1$ und $F_2$ sind dabei die Funktionen, die die Topografie der jeweiligen Plattenoberfläche beschreiben.

a ist die Relativverschiebung der beiden Platten zueinander in der x-Richtung;

b ist die Relativverschiebung der beiden Platten zueinander in der y-Richtung.

x und y sind die Koordinaten, die die vom Bündel des Beleuchtungslichts genutzte Plattenfläche aufspannen. x und y verlaufen senkrecht zur Ausbreitungsrichtung des Beleuchtungslichts.

Eine Ausgestaltung eines Keilkörpers als Beleuchtungswinkel-Variationseinheit nach Anspruch 7 vermeidet eine unerwünscht starke Ablenkwirkung in einer Ebene senkrecht zur Ablenkebene. Dies vermeidet ein unerwünschtes Kanal-Übersprechen zwischen verschiedenen Kanälen der Rasteranordnung senkrecht zur Ablenkebene. Der Absolutwert der Steigung $|dy/dx|$ kann mindestens 2,5 oder mindestens 3 betragen und kann auch noch größer sein.

Eine Ausführung nach Anspruch 8 kann so gestaltet sein, dass abgesehen von einer gewünschten Variation einer Gesamt-Ablenkwirkung der Beleuchtungswinkel-Variationseinrichtung keine weiteren störenden Änderungen in der das Beleuchtungslicht führenden Wirkung der Beleuchtungsoptik eingeführt wird. Die verlagerbare Beleuchtungswinkel-Variationseinheit kann insbesondere drehbar um die optische Achse der Beleuchtungsoptik ausgeführt sein. Insbesondere eine stufenlose Änderung der Variation einer Ablenkung durch die Beleuchtungswinkel-Variationseinrichtung kann erreicht werden.

Ein Verlagerungsantrieb nach Anspruch 9 ermöglicht eine automatisierte Verlagerung der verlagerbaren Beleuchtungswinkel-Variationseinheit zur Rasteranordnung. Eine Verlagerung durch den Verlagerungsantrieb kann längs der Strahlrichtung des Beleuchtungslichts erfolgen. Alternativ oder zusätzlich kann die Verlagerung durch den Verlagerungsantrieb auch quer zur Verlagerungsrichtung sein, beispielsweise radial zur optischen Achse der Beleuchtungsoptik. Der Verlagerungsantrieb kann eine Verlagerung in Bezug auf mindestens einen der sechs möglichen Freiheitsgrade oder auch in Bezug auf mehrere Freiheitsgrade herbeiführen. Der Verlagerungsantrieb kann insbesondere alle Verlagerungsvarianten ermöglichen, die vorstehend in Bezug auf den Begriff "Verlagerung" bereits angesprochen wurden.

Eine Messeinrichtung nach Anspruch 10 ermöglicht eine Überwachung des Beleuchtungsparameters, beispielsweise eine Überwachung einer einzustellenden Beleuchtungswinkel-Verteilung, also eines Beleuchtungssettings, sowie eine Vermessung von gegebenenfalls auftretenden Drifteffekten. Als Beleuchtungsparameter kann beispielsweise ein Telezentriewert in Abhängigkeit über mindestens eine Felddimension gemessen werden. Eine Telezentriewert-Messeinrichtung, die zum Einsatz kommen kann, ist beispielsweise beschrieben in der DE 10 2005 026 628 A1 und in der DE 10 2007 055 096 A1.

Eine Anordnung nach Anspruch 11 ermöglicht eine geregelte Einstellung der Beleuchtungswinkel-Variationseinrichtung, sodass beispielsweise ein Ist-Wert des gemessenen Beleuchtungsparameters einem vorgegebenen Sollwert nachgeführt werden kann.

Mit einer entsprechend eine Messeinrichtung, eine Steuer-/Regeleinheit und einen Verlagerungsantrieb aufweisenden Beleuchtungsoptik lässt sich beispielsweise eine Feed-Forward-Korrektur erreichen. Hierfür wird durch eine vorbereitende Kalibriermessung bestimmt, wie sich ein Beleuchtungsparameter, beispielsweise ein Telezentriewert, über das Beleuchtungsfeld bei diesem eingestellten Beleuchtungssetting ändert. Sobald im Projektionsbetrieb ein entsprechendes Beleuchtungssetting eingestellt wird, wird die verlagerbare Beleuchtungswinkel-Variationseinheit gesteuert in eine Position gebracht, in der ein zu korrigierender Beleuchtungsparameter, beispielsweise der Telezentriewert, entsprechend der sich aus der Kalibriermessung ergebenden Änderung bei Einstellung dieses Beleuchtungssettings korrigiert wird. Bei dieser Betriebsart "Feed-Forward-Korrektur" ist nicht zwingend notwendig, dass die Messeinrichtung während des Projektionsbetriebs arbeitet. Zudem genügt es, wenn eine Steuereinheit zum Einsatz kommt, die mit dem Verlagerungsantrieb in Signalverbindung steht. Eine Regelfunktion ist nicht erforderlich.

Alternativ oder zusätzlich kann eine entsprechende Beleuchtungsoptik mit einer Messeinrichtung, einer Steuer-/Regeleinheit und einem Verlagerungsantrieb zu einem geregelten Betrieb der Beleuchtungsoptik genutzt werden. In diesem Falle wird während des Projektionsbetriebs ein Beleuchtungsparameter, beispielsweise ein Telezentriewert, über die Messeinrichtung überwacht und über die Steuer-/ Regeleinheit durch entsprechendes Nachstellen des Verlagerungsantriebs nachgeregelt. Hierzu wird ein über die Messeinrichtung gemessener Ist-Beleuchtungsparameter mit einem vorgegebenen Soll-Beleuchtungsparameter verglichen und abhängig von diesem Vergleichswert ein Steuersignal zur Ansteuerung des Verlagerungsantriebs generiert.

Soweit die Beleuchtungswinkel-Variationseinrichtung zwei einander benachbarte Beleuchtungswinkel-Variationseinheiten aufweist, die als refraktive optische Platten ausgeführt sind, so können die beiden Platten einander zugewandte, gekrümmte Oberflächen aufweisen. Die voneinander abgewandten Oberflächen können plan ausgeführt sein. Bei Varianten derartiger Beleuchtungswinkel-Variationseinrichtungen können die für die Beleuchtungswinkel-Variation wirksamen, gekrümmten optischen Oberflächen auch voneinander abgewandt angeordnet sein. Bei weiteren Varianten der Beleuchtungswinkel-Variationseinrichtung können die planen optischen Flächen durch gekrümmte optische Flächen, beispielsweise durch sphärische Flächen, ersetzt sein. Dies kann insbesondere bei Beleuchtungswinkel-Variationseinheiten zum Einsatz kommen, die keine Verschiebung quer zur Strahlrichtung des Beleuchtungslichts erfahren.

Die Vorteile eines optischen Systems nach Anspruch 12, einer Projektionsbelichtungsanlage nach Anspruch 13, eines Herstellungsverfahrens nach Anspruch 14 sowie eines mikro- bzw. nanostrukturierten Bauelements, das nach einem solchen Verfahren hergestellt ist, entsprechen denen, die vorstehend unter Bezugnahme auf die erfindungsgemäße Beleuchtungsoptik bereits erläutert wurden.

Ausführungsbeispiele der Erfindung werden nachfolgend anhand der Zeichnung näher erläutert. In dieser zeigen:

Fig. 1 schematisch einen Meridionalschnitt durch ein erfindungsgemäßes Beleuchtungssystem innerhalb einer Mikrolithographie-Projektionsbelichtungsanlage mit einer Beleuchtungswinkel-Variationseinrichtung vor einem Rastermodul mit einer zweistufigen Rasteranordnung;

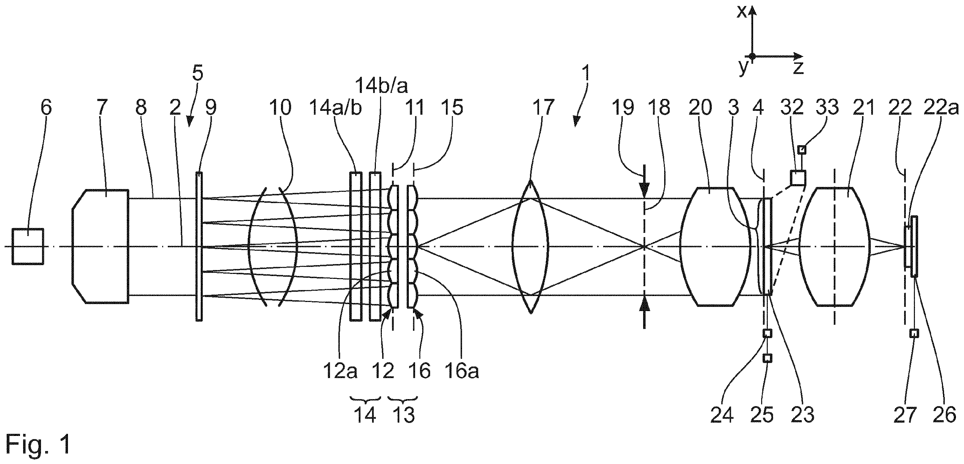

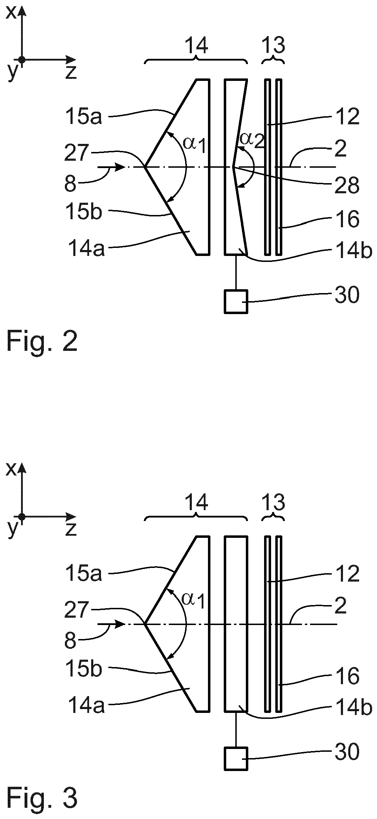

Fig. 2 schematisch einen Ausschnitt einer Beleuchtungsoptik des Beleuchtungssystems nach Fig. 1, wobei zwei Beleuchtungswinkel-Variationseinheiten der Beleuchtungswinkel-Variationseinrichtung in einer ersten Relativposition zueinander dargestellt sind, in der die verlagerbare Beleuchtungswinkel-Variationseinheit, die Beleuchtungslicht beeinflusst, das über die Beleuchtungsoptik geführt wird, in einer Ablenkebene eine kleinere und gegenläufige Ablenkwirkung im Vergleich zur ersten Beleuchtungswinkel-Variationseinheit hat, wobei die beiden Beleuchtungswinkel-Variationseinheiten als Dachkanten-Prismen ausgeführt sind;

Fig. 3 die Beleuchtungswinkel-Variationseinrichtung nach Fig. 2 mit einer Relativpositionierung der beiden Beleuchtungswinkel-Variationseinheiten zueinander, bei der die verlagerbare Beleuchtungswinkel-Variationseinheit in der dargestellten Ablenkebene in einer Neutralposition vorliegt, also keine Ablenkwirkung auf das Beleuchtungslicht hat;

Fig. 4 und 5 schematisch eine ablenkende Wirkung der Beleuchtungswinkel-Variationseinrichtung mit den Beleuchtungswinkel-Variationseinheiten in den Relativpositionen nach Fig. 2 und 3;

Fig. 6 in einer zur Fig. 2 ähnlichen Darstellung eine weitere Variante einer Beleuchtungswinkel-Variationseinrichtung vor dem Rastermodul, wobei die Beleuchtungswinkel-Variationseinheiten als Zylinderlinsen mit elliptisch gekrümmt geformten brechenden Flächen ausgeführt sind;

Fig. 7 die Beleuchtungswinkel-Variationseinrichtung nach Fig. 6 in einer Relativposition der Beleuchtungswinkel-Variationseinheiten nach Fig. 3, also mit neutraler verlagerbarer Beleuchtungswinkel-Variationseinheit;

Fig. 8 in einer zur Fig. 2 ähnlichen Darstellung eine weitere Ausführung einer BeleuchtungswinkelVariationseinrichtung mit als Dachkanten-Prismen ausgeführten Beleuchtungswinkel-Variationseinheiten, wobei die verlagerbare vom Beleuchtungslicht durchtretene Beleuchtungswinkel-Variationseinheit eine kleinere absolute Ablenkwirkung hat als die weitere Beleuchtungswinkel-Variationseinheit und wobei sich die Ablenkwirkungen der beiden Beleuchtungswinkel-Variationseinheiten verstärken;

Fig. 9 in einer zur Fig. 3 ähnlichen Darstellung die Beleuchtungswinkel-Variationseinrichtung nach Fig. 8 mit der verlagerbaren Beleuchtungswinkel-Variationseinheit in einer Neutralposition;

Fig. 10 in einer zur Fig. 8 ähnlichen Darstellung eine weitere Ausführung einer BeleuchtungswinkelVariationseinrichtung, wobei wiederum die Beleuchtungswinkel-Variationseinheiten als Zylinderlinsen ausgeführt sind, wobei die weitere BeleuchtungswinkelVariationseinheit im Vergleich zur verlagerbaren Beleuchtungswinkel-Variationseinheit eine stärkere Ablenkwirkung hat und wobei sich die Ablenkwirkungen der beiden Beleuchtungswinkel-Variationseinheiten verstärken;

Fig. 11 in einer zu Fig. 3 ähnlichen Darstellung die Beleuchtungswinkel-Variationseinrichtung nach Fig. 10 mit der verlagerbaren Beleuchtungswinkel-Variationseinheit in einer Neutralposition;

Fig. 12 schematisch das Rastermodul nach Fig. 1 und eine nachgeschaltete Übertragungsoptik zur Übertragung des Beleuchtungslichts vom Rastermodul in ein Beleuchtungsfeld, dargestellt am Beispiel einer Feld-Zwischenebene;

Fig. 13 stärker im Detail die beleuchtungsfeldabhängigen Beleuchtungswinkel-Intensitätsverteilungen, die von zwei der Fig. 12 dargestellten Kanälen im Beleuchtungsfeld erzeugt werden;

Fig. 14 Varianten eines Telezentrie-Wertes über eine Feldhöhe des Beleuchtungsfeldes, die je nach einer Relativpositionierung der beiden Beleuchtungswinkel-Variationseinheiten der Beleuchtungswinkel-Variationseinrichtung nach Fig. 1 einstellbar sind;

Fig. 15 stark schematisch einen Meridionalschnitt durch eine weitere Ausführung einer Beleuchtungsoptik, die anstelle der Beleuchtungsoptik nach Fig. 1 zum Einsatz kommen kann, dargestellt zwischen einer Lichtquelle und einem Rastermodul mit einer zweistufigen Rasteranordnung;

| Fig. 16 - 18 | in einer zu Fig. 15 ähnlichen Darstellung EinstellVarianten der Beleuchtungsoptik nach Fig. 15, wobei eine zwei Linsen umfassende BeleuchtungswinkelVariationseinrichtung schematisch zu einer Linse zusammengefasst dargestellt ist; |
| Fig. 19 | in einer zu Fig. 15 ähnlichen Darstellung eine weitere Ausführung einer BeleuchtungswinkelVariationseinrichtung für die Beleuchtungsoptik nach Fig. 15; |
| Fig. 20 | Die Beleuchtungswinkel-Variationseinrichtung nach Fig. 19 in einer weiteren Relativposition zum Rastermodul, verschwenkt im Vergleich zur Relativposition nach Fig. 19 um 90° um eine optische Achse der Beleuchtungsoptik; |
| Fig. 21 | schematisch in einem Diagramm die Abhängigkeit einer Amplitude A eines Feldverlaufs einer Intensität über das Objektfeld von einem Ablenkwinkel $\beta$, erzeugt durch die Beleuchtungswinkel-Variationseinrichtung nach den Fig. 19 und 20, wobei der Feldverlauf der Amplitude in den beiden Erstreckungsdimensionen x und y des Objektfeldes angegeben ist; |
| Fig. 22 - 24 | drei Relativpositionen der Beleuchtungswinkel-Variationseinrichtung nach den Fig. 19 und 20 in einer Aufsicht, wobei Fig. 22 die Relativposition nach Fig. 19, Fig. 23 eine Zwischen-Relativposition und Fig. 24 die Relativposition nach Fig. 20 zeigt; |
| Fig. 25 | perspektivisch eine brechende Oberfläche der Beleuchtungswinkel-Variationseinrichtung nach den Fig. 19 und 20; |
| Fig. 26 und 27 | zwei Beispiele einer Beaufschlagung der Beleuchtungswinkel-Variationseinrichtung nach Fig. 19 mit einem Mikrospiegelarray (multi-mirror array, MMA) der Beleuchtungsoptik nach Fig. 15, wobei die nacheinander beaufschlagten Komponenten jeweils in einer Aufsicht und zur vereinfachten Darstellung nebeneinander gezeigt sind; |
| Fig. 28 | eine weitere Variante einer Beleuchtungswinkel-Variationseinrichtung, dargestellt in einer Aufsicht in Strahlrichtung des Beleuchtungslichts, wobei auch eine eingangsseitige Fläche des Rastermodul gezeigt ist; |
| Fig. 29 | in einer zur Fig. 28 ähnlichen Darstellung zwei Beleuchtungswinkel-Variationseinheiten mit im Vergleich zu denjenigen nach Fig. 28 inverser Ablenkwirkung; |
| Fig. 30 | in einer zu Fig. 28 ähnlichen Darstellung eine weitere Variante einer BeleuchtungswinkelVariationseinrichtung; |
| Fig. 31 und 32 | in einer zu Fig. 19 ähnlichen Darstellung verschiedene Relativpositionen von Beleuchtungswinkel-Variationseinheiten nach Art der Beleuchtungswinkel-Variationseinrichtung nach den Fig. 28 und 29 vor dem Rastermodul der Beleuchtungsoptik nach Fig. 15; |
| Fig. 33 und 34 | zwei Anordnungsvarianten einer Beleuchtungswinkel-Variationseinrichtung nach Fig. 32; |
| Fig. 35 | in einer zu Fig. 1 ähnlichen Darstellung des Beleuchtungssystems mit einer zusätzlichen Anordnungsvariante einer Beleuchtungswinkel-Variationseinheit in einer Feld-Zwischenebene vor einem Beleuchtungsfeld; |
| Fig. 36 | eine weitere Ausführung einer Beleuchtungswinkel-Variationseinrichtung mit zwei relativ zueinander senkrecht zum Strahlengang des Beleuchtungslichts verschiebbar angeordneten refraktiven optischen Platten; |
| Fig. 37 | die Ausführung nach Fig. 36 in einer Verschiebeposition der beiden Platten zueinander, bei der eine der beiden Platten relativ zur anderen parallel zu einer Objektverlagerungsrichtung verschoben ist; |

| Fig. 38 | in einer zu Fig. 14 ähnlichen Darstellung verschiedene Variationen eines Telezentriewertes über die Feldhöhe des Beleuchtungsfeldes, jeweils abhängig von einer Relativverschiebung der beiden Platten der Ausführung nach den Fig. 36 und 37 zueinander parallel zur Objektverlagerungsrichtung; |
| Fig. 39 | ein Höhenprofil einer von zwei Platten einer weiteren Ausführung einer BeleuchtungswinkelVariationseinrichtung, die derjenigen nach den Fig. 36 und 37 ähnlich ist, mit einem Höhenprofil mit einem Verlauf über die Feldhöhe gemäß einer Kosinusfunktion; |
| Fig. 40 | ein Höhenprofil der Platten nach Fig. 39, gesehen in einer Aufsicht auf die profilierte, also gekrümmte, Plattenoberfläche; |
| Fig. 41 | in einer zu Fig. 37 ähnlichen Darstellung eine weitere Ausführung einer Beleuchtungswinkel-Variationseinrichtung mit zwei relativ zueinander senkrecht zur Objektverlagerungsrichtung verschiebbar angeordneten refraktiven optischen Platten; |
| Fig. 42 | die beiden Platten nach Fig. 41 in einer Verschiebeposition relativ zueinander nach einer Verschiebung senkrecht zur Objektverlagerungsrichtung; |
| Fig. 43 | eine Variation eines Luftspaltes zwischen den beiden Platten in der Stellung nach Fig. 42, abhängig von der Feldhöhe über das Beleuchtungsfeld; |
| Fig. 44 | ein aufgrund der Luftspalt-Variation nach Fig. 43 resultierender Telezentriewert, wiederum aufgetragen über die Feldhöhe; |
| Fig. 45 | in einer zu Fig. 40 ähnlichen Höhenprofil-Darstellung eine Oberflächenform einer gekrümmten Oberfläche einer von zwei Platten einer weiteren Ausführung einer Beleuchtungswinkel-Variationseinrichtung entsprechend einer Kombination derjenigen nach den Fig. 36 und 41; |
| Fig. 46 | einen Verlauf eines Telezentriewertes über die Feldhöhe, erzeugt mit der Beleuchtungswinkel-Variationseinrichtung mit Platten nach Fig. 45, bei der die Platten, ausgehend von einer Nullstellung, senkrecht zur Objektverlagerungsrichtung zueinander verschoben sind; |
| Fig. 47 | einen Verlauf eines Telezentriewertes über die Feldhöhe, erzeugt mit der Beleuchtungswinkel-Variationseinrichtung mit Platten nach Fig. 45, bei der die Platten, ausgehend von einer Nullstellung, parallel zur Objektverlagerungsrichtung zueinander verschoben sind; |
| Fig. 48 | einen Verlauf eines Telezentriewertes über die Feldhöhe, erzeugt mit der Beleuchtungswinkel-Variationseinrichtung mit Platten nach Fig. 45, bei der die Platten, ausgehend von einer Nullstellung, sowohl senkrecht als auch parallel zur Objektverlagerungsrich-tung zueinander verschoben sind; |
| Fig. 49 | einen Schnitt durch einen Luftspalt zwischen zwei Platten einer weiteren Ausführung einer Beleuchtungswinkel-Variationseinrichtung, bei der die Platten, ausgehend von einer Nullstellung, senkrecht zur Objektverlagerungsrichtung zueinander verschoben sind, wobei sich eine V-förmige Variation einer Luftspalterstreckung über eine Plattenkoordinate parallel zur Feldhöhe ergibt; |
| Fig. 50 | die V-förmige Variation des Luftspaltes bei der Beleuchtungswinkel-Variationseinrichtung nach Fig. 49; |
| Fig. 51 | einen Verlauf des Telezentriewertes über die Feldhöhe bei der Beleuchtungswinkel-Variationseinrichtung in der Relativstellung der beiden Platten nach Fig. 49; |
| Fig. 52 | in einer zu den Fig. 40 und 45 ähnlichen Höhenprofildarstellung eine Oberflächenform einer Platte einer weiteren Ausführung einer Beleuchtungswinkel-Variationseinrichtung, ähnlich zu denen nach den Fig. 37 und 42; |
| Fig. 53 | in einer zu Fig. 49 ähnlichen Darstellung eine Luftspalt-Variation über eine Plattenkoordinate parallel zur Feldhöhe bei der Beleuchtungswinkel-Variationseinrichtung mit Platten nach Fig. 52, bei der die Platten, ausgehend von einer Nullstellung, parallel zur Objektverlagerungsrichtung zueinander verschoben sind; |

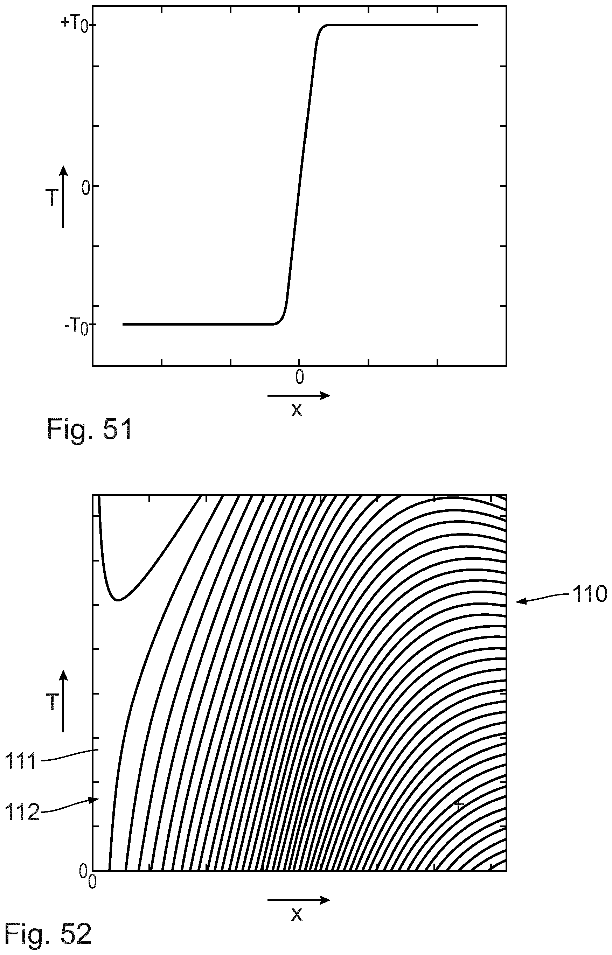

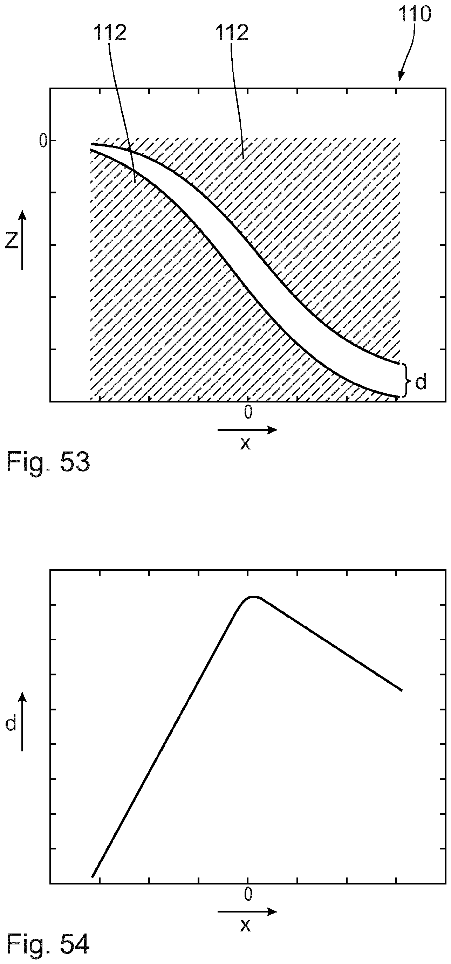

Fig. 54    bei einer gegebenen Relativverschiebung in x- und y-Richtung der Platten einer Beleuchtungswinkel-Variationseinrichtung nach Fig. 52 eine Luftspalt-Variation zwischen den Platten über eine Plattenkoordinate parallel zur Feldhöhe;

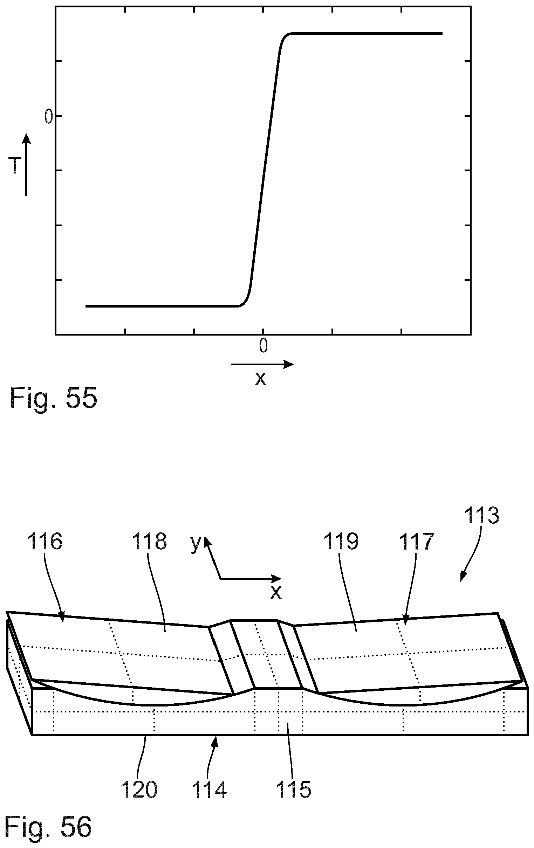

Fig. 55    einen Verlauf eines Telezentriewertes über die Feldhöhe bei der Luftspalt-Variation nach Fig. 54; und

Fig. 56    eine weitere Ausführung einer Beleuchtungswinkel-Variationseinrichtung mit zwei verschwenkbaren plankonvexen Zylinderlinsen.

Figur 1 zeigt schematisch eine Mikrolithographie-Projektionsbelichtungsanlage 1, die als Wafer-Scanner ausgeführt ist und bei der Herstellung von Halbleiterbauelementen und anderen fein strukturierten Bauteilen eingesetzt wird. Die Projektionsbelichtungsanlage 1 arbeitet zur Erzielung von Auflösungen bis zu Bruchteilen von Mikrometern mit Licht insbesondere aus dem tiefen Ultraviolettbereich (VUV).

Zur Verdeutlichung von Lagebeziehungen wird in der Zeichnung ein kartesisches xyz-Koordinatensystem verwendet. Die x-Richtung verläuft in der Fig. 1 nach oben. Die y-Richtung verläuft in der Fig. 1 senkrecht zur Zeichenebene und aus dieser heraus. Die z-Richtung verläuft in der Fig. 1 nach rechts.

Eine Scanrichtung y der Projektionsbelichtungsanlage 1 verläuft senkrecht zur Zeichenebene der Fig. 1 und 2. Im in der Figur 1 dargestellten Meridionalschnitt sind alle optischen Komponenten der Projektionsbelichtungsanlage 1 längs einer optischen Achse 2 aufgereiht, die längs der z-Richtung verläuft. Es versteht sich, dass auch beliebige Faltungen der optischen Achse 2 möglich sind, insbesondere um die Projektionsbelichtungsanlage 1 kompakt zu gestalten. Auch bei den nachfolgenden Figuren verlaufen, soweit nichts anderes erläutert ist, die x-Achsen parallel zur x-Achse nach Fig. 1 und die y-Achsen parallel zur y-Achse nach Fig. 1.

Zur definierten Ausleuchtung eines Objekt- bzw. Beleuchtungsfeldes 3 in einer Retikelebene 4, in der eine zu übertragende Struktur in Form eines nicht näher dargestellten Retikels angeordnet ist, dient eine Beleuchtungsoptik eines insgesamt mit 5 bezeichnetes Beleuchtungssystem der Projektionsbelichtungsanlage 1. Als primäre Lichtquelle 6 dient ein $F_2$-Laser mit einer Arbeitswellenlänge von 157 nm, dessen Beleuchtungslichtstrahl koaxial zur optischen Achse 2 ausgerichtet ist. Andere UV-Lichtquellen, beispielsweise ein ArF-Excimer-Laser mit 193 nm Arbeitswellenlänge, ein Krf-Excimer-Laser mit 248 nm Arbeitswellenlänge sowie primäre Lichtquellen mit größeren oder kleineren Arbeitswellenlängen sind ebenfalls möglich.

Der von der Lichtquelle 6 kommende Lichtstrahl mit kleinem Rechteckquerschnitt trifft zunächst auf eine Strahlaufweitungsoptik 7, die einen austretenden Strahl 8 mit weitgehend parallelem Licht und größerem Rechteckquerschnitt erzeugt. Die Strahlaufweitungsoptik 7 kann Elemente enthalten, die zur Kohärenzreduktion des Beleuchtungslichts dienen. Das durch die Strahlaufweitungsoptik 7 weitgehend parallelisierte Laserlicht trifft anschließend auf ein diffraktives optisches Element (DOE) 9, das als computergeneriertes Hologramm zur Erzeugung einer Beleuchtungslicht-Winkelverteilung ausgebildet ist. Die durch das DOE 9 erzeugte Winkelverteilung wird beim Durchtritt durch eine Fourier-Linsenanordnung bzw. einen Kondensor 10, der im Abstand seiner Brennweite vom DOE 9 positioniert ist, in eine zweidimensionale, also senkrecht zur optischen Achse 2 ortsabhängige Beleuchtungslicht-Intensitätsverteilung umgewandelt. Die so erzeugte Intensitätsverteilung ist daher in einer ersten Beleuchtungsebene 11 des Beleuchtungssystems 5 vorhanden. Zusammen mit dem Kondensor 10 stellt das DOE 9 also eine Lichtverteilungseinrichtung zur Erzeugung einer zweidimensionalen Beleuchtungslicht-Intensitätsverteilung dar.

Im Bereich der ersten Beleuchtungsebene 11 ist eine erste Rasteranordnung 12 eines Rastermoduls 13 angeordnet, das auch als Wabenkondensor bezeichnet wird. Das Rastermodul 13 dient zusammen mit einer im Lichtweg vor diesem angeordneten Beleuchtungswinkel-Variationseinrichtung 14 zur Erzeugung einer definierten Intensitäts- und Beleuchtungswinkelverteilung des Beleuchtungslichts. Die Beleuchtungswinkel-Variationseinrichtung 14 beeinflusst den Ablenkwinkel des Beleuchtungslichtstrahls 8. Die Beleuchtungswinkel-Variationseinrichtung 14 umfasst zwei Beleuchtungswinkel-Variationseinheiten 14a, 14b, die vom Beleuchtungslichtstrahl 8 nacheinander beaufschlagt werden. Die optische Wirkung der Beleuchtungswinkel-Variationseinrichtung 14 wird nachfolgend anhand verschiedener Ausführungsbeispiele noch näher erläutert.

In einer weiteren Beleuchtungsebene 15, die eine Fourier-transformierte Ebene zur Beleuchtungsebene 11 ist, ist eine zweite Rasteranordnung 16 angeordnet. Die beiden Rasteranordnungen 12, 16 stellen den Wabenkondensor 13 des Beleuchtungssystems 5 dar. Die weitere Beleuchtungsebene 15 ist eine Pupillenebene des Beleuchtungssystems 5.

Dem Rastermodul 13 nachgeordnet ist ein weiterer Kondensor 17, der auch als Feldlinse bezeichnet wird. Zusammen mit der zweiten Rasteranordnung 16 bildet der Kondensor 17 die Beleuchtungsebene 11 in eine Feld-Zwischenebene 18 des Beleuchtungssystems 5 ab. In der Feld-Zwischenebene 18 kann ein Retikel-Masking-System (REMA) 19 angeordnet sein, welches als verstellbare Abschattungsblende zur Erzeugung eines scharfen Randes der Beleuchtungslicht-Intensitätsverteilung dient. Ein nachfolgendes Objektiv 20 bildet die Feld-Zwischenebene 18 auf das Retikel, das heißt die Lithographievorlage ab, das sich in der Retikelebene 4 befindet. Mit einem Projektionsobjektiv 21 wird die Retikelebene 4 auf eine Waferebene 22 auf einen Wafer 22a abgebildet, der intermittierend oder kontinuierlich in der Scan-Richtung y verschoben wird.

Die erste Rasteranordnung 12 weist einzelne erste Rasterelemente 12a auf, die spalten- und zeilenweise angeordnet sind. Die ersten Rasterelemente 12a haben eine rechteckige Apertur mit einem x/y-Aspektverhältnis (y: Scanrichtung) von beispielsweise 2/1. Auch andere, insbesondere größere Aspektverhältnisse der ersten Rasterelemente 12a sind möglich.

Der Meridionalschnitt nach Figur 1 geht entlang einer Rasterspalte. Die ersten Rasterelemente 12a sind insbesondere als Mikrolinsen, z. B. mit positiver Brechkraft, ausgebildet. Die Rechteckform der ersten Rasterelemente 12a entspricht der Rechteckform des Beleuchtungsfelds 3. Die ersten Rasterelemente 12a sind in einem ihrer Rechteckform entsprechenden Raster direkt aneinander angrenzend, das heißt im Wesentlichen flächenfüllend, angeordnet. Die ersten Rasterelemente 12a werden auch als Feldwaben bezeichnet.

Im Lichtweg hinter den ersten Rasterelementen 12a der ersten Rastanordnung 12 sind, jeweils den Kanälen zugeordnet, zweite Rasterelemente 16a der zweiten Rasteranordnung 16 angeordnet. Die zweiten Rasterelemente 16a sind ebenfalls als Mikrolinsen mit insbesondere positiver Brechkraft ausgebildet. Die zweiten Rasterelemente 16a werden auch als Pupillenwaben bezeichnet, die in der Beleuchtungsebene 15, also in einer Pupillenebene des Beleuchtungssystems 5 angeordnet sind. Die Beleuchtungsebene 15 ist konjugiert zu einer Pupillenebene des Projektionsobjektivs 21. Die zweiten Rasterelemente 16a bilden zusammen mit der Feldlinse 17 die in der Beleuchtungsebene 11 angeordneten ersten Rasterelemente 12a, also die Feldwaben, in die Feld-Zwischenebene 18 ab. Hierbei werden die Bilder der ersten Rasterelemente 12a in der Feld-Zwischenebene 18 überlagert.

Zur Halterung eines Retikels 23, das in der Fig. 1 schematisch dargestellt ist, in der Retikelebene 4 dient ein ebenfalls schematisch dargestellter Objekthalter 24, der über einen Objektverlagerungsantrieb 25 in der Scanrichtung y verlagerbar ist. Der Wafer 22a wird von einem Waferhalter 26 getragen, der wiederum über einen Waferverlagerungsantrieb 27 in der Scanrichtung y verlagerbar ist. Beide Verlagerungsantriebe 25, 27 können auch eine Verlagerung der Halter 24, 26 senkrecht zur Scanrichtung, also in der x-Richtung nach Fig. 1, quer zur Strahlrichtung des Beleuchtungslichts 8 herbeiführen.

Anhand der Fig. 2 bis 5 wird nachfolgend eine erste Ausführung für die Beleuchtungswinkel-Variationseinrichtung 14 beschrieben. Die Rasteranordnungen 12, 16 des Rastermoduls 13 sind in den Fig. 2 ff., sofern überhaupt dargestellt, lediglich stark schematisch wiedergegeben.

Die Beleuchtungswinkel-Variationseinrichtung 14 nach den Fig. 2 bis 5 umfasst zwei Beleuchtungswinkel-Variationseinheiten 14a, 14b, die jeweils als Dachkanten-Prismen ausgeführt sind, deren Dachkanten 27, 28 parallel zur y-Achse, also parallel zur Scanrichtung verlaufen. Die Dachkanten-Prismaausführung erstreckt sich über eine gesamte Nutzapertur des Rastermoduls 13. Die vom Beleuchtungslichtstrahl 8 zuerst durchtretene Beleuchtungswinkel-Variationseinheit 14a ist als konvexes Dachkantenprisma und die nachfolgende Beleuchtungswinkel-Variationseinheit 14b als konkaves Dachkantenprisma ausgeführt. Die vom Beleuchtungslicht 8 zuerst durchtretene Beleuchtungswinkel-Variationseinheit 14a ist als statische Einheit ausgeführt. Diese nachfolgende Beleuchtungswinkel-Variationseinheit 14b ist als verlagerbare Beleuchtungswinkel-Variationseinheit ausgeführt, wie nachfolgend noch beschrieben wird. Die Dachkante 27 der Beleuchtungswinkel-Variationseinheit 14a ist dem einfallenden Beleuchtungslichtstrahl 8 zugewandt. Die Dachkante 27, die die höchste Erhebung einer Eintrittsfläche der ersten Beleuchtungswinkel-Variationseinheit 14a darstellt, wird vom Beleuchtungslicht 8 also zuerst erreicht. Eine Austrittsfläche der zuerst vom Beleuchtungslicht 8 durchtretenen, statischen Beleuchtungswinkel-Variationseinheit 14a ist genauso wie eine Eintrittsfläche der nachfolgend vom Beleuchtungslicht 8 durchtretenen, verlagerbaren Beleuchtungswinkel-Variationseinheit 14b als plane Fläche realisiert. Eine Austrittsfläche der verlagerbaren Beleuchtungswinkel-Variationseinheit 14b weist die Dachkante 28 auf, die gleichzeitig den Bereich der Beleuchtungswinkel-Variationseinheit 14b mit einer geringsten Materialstärke darstellt.

Die Beleuchtungswinkel-Variationseinheiten 14a, 14b stellen refraktive Einheiten dar, sind also für den Beleuchtungslichtstrahl 8 durchlässig. Die Beleuchtungswinkel-Variationseinheiten 14a, 14b sind aus für VUV-Lichtwellenlägen hochtransmissivem Material.

Bei einer weiteren, nicht dargestellten Ausführung wird zuerst die verlagerbare Beleuchtungswinkel-Variationseinheit 14b vom Beleuchtungslicht 8 durchtreten und anschließend die statische Beleuchtungswinkel-Variationseinheit 14a. Im Vergleich zur beispielsweise nach den Fig. 2 bis 5 dargestellten Ausführungen vertauschen die beiden Beleuchtungswinkel-Variationseinheiten 14a, 14b also ihren Platz.

Bei einer weiteren, nicht dargestellten Ausführung kann die statische Beleuchtungswinkel-Variationseinheit 14a auch komplett entfallen. Die Beleuchtungswinkel-Variationseinrichtung 14 umfasst dann ausschließlich mindestens eine verlagerbare Beleuchtungswinkel-Variationseinheit.

Eine erste Dachfläche 15a der statischen Beleuchtungswinkel-Variationseinrichtung 14a stellt aufgrund ihrer ablenkenden brechenden Wirkung für das Beleuchtungslicht 8 einen Winkelvariationsabschnitt dar. Eine zweite Dachfläche 15b stellt entsprechend einen weiteren Winkelvariationsabschnitt der statischen Beleuchtungswinkel-Variationseinrichtung 14a dar.

Ein kleinster Winkel $\alpha_1$, den die beiden an die Dachkante 27 angrenzenden Eintritts-Flächenabschnitte 15a, 15b der Beleuchtungswinkel-Variationseinheit 14a zueinander einnehmen, ist kleiner als ein entsprechender kleinster Winkel $\alpha_2$, den die beiden über die Dachkante 28 einander angrenzenden Eintrittsflächenabschnitte der Beleuchtungswinkel-Variationseinheit 14b zueinander einnehmen. Eine brechende, ablenkende Wirkung der statischen Beleuchtungswinkel-Variationseinheit 14a ist also größer als eine entsprechende ablenkende Wirkung der nachfolgenden verlagerbaren Beleuchtungswinkel-Variationseinheit 14b. Alternativ sind auch Ausführungen möglich, bei denen eine brechende, ablenkende Wirkung der statischen Beleuchtungswinkel-Variationseinheit 14a kleiner ist als eine entsprechende ablenkende Wirkung der nachfolgenden verlagebaren Beleuchtungswinkel-Variationseinheit 14b.

Aufgrund der Dachkanten-Unterteilung der beiden Beleuchtungswinkel-Variationseinheiten 14a, 14b lenken diese den Beleuchtungslichtstrahl 8, der auf die Beleuchtungswinkel-Variationseinrichtung 14 trifft, in den zwei Winkelvariationsabschnitten, die den beiden über die Dachkanten 27, 28 aneinander angrenzenden Flächenabschnitten 15a, 15b entsprechen, in jeweils einer Ablenkebene xz mit unterschiedlichen Ablenkwinkeln ab.

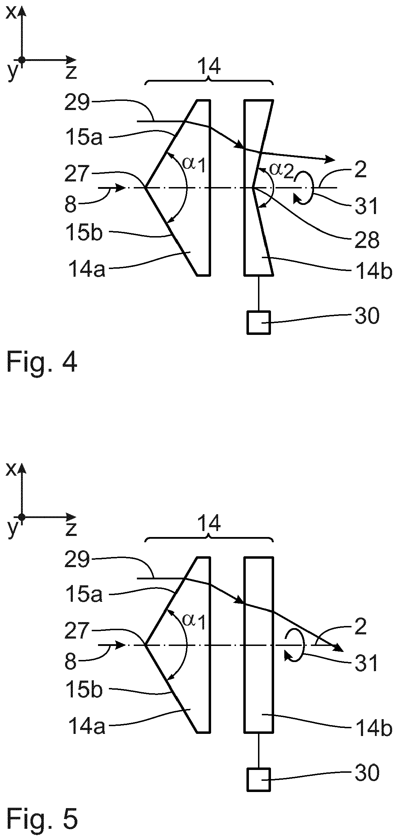

In der Relativstellung der beiden Beleuchtungswinkel-Variationseinheiten 14a, 14b, die in den Fig. 2 und 4 dargestellt ist, erfolgt diese Ablenkung jeweils in der Ablenkebene xz senkrecht zur Objektverlagerungsrichtung y. Dies ist in der Fig. 4 am Beispiel eines Einzelstrahls 29 des Beleuchtungslichtstrahls 8 dargestellt. Grundsätzlich kann auch, je nach Relativstellung der beiden Beleuchtungswinkel-Variationseinheiten 14a, 14b zueinander, eine Ablenkung in einer hierzu senkrechten yz-Ebene erfolgen, was für die nachfolgende Erläuterung jedoch nicht weiter interessiert.

Aufgrund des größeren Dachkantenwinkels $\alpha_2$ der verlagerbaren Beleuchtungswinkel-Variationseinheit 14b im Vergleich zur statischen Beleuchtungswinkel-Variationseinheit 14a erzeugt die verlagerbare Beleuchtungswinkel-Variationseinheit 14b eine kleinere maximale Ablenkwirkung als die statische Beleuchtungswinkel-Variationseinheit 14a. Auch dies ist in der Fig. 4 dargestellt, wo der Einzelstrahl 29 parallel zur z-Achse verlaufend in die statische Beleuchtungswinkel-Variationseinheit 14a eintritt. Ein Propagationswinkel des Einzelstrahls 29 zur z-Achse ist zwischen den beiden Beleuchtungswinkel-Variationseinheiten 14a, 14b größer als nach dem Austritt aus der verlagerbaren Beleuchtungswinkel-Variationseinheit 14b. Bei einer alternativen Ausführungsform, die nicht dargestellt ist, kann ein Propagationswinkel des Einzelstrahls 29 zur z-Achse zwischen den beiden Beleuchtungswinkel-Variationseinheiten 14a, 14b auch kleiner sein als nach dem Austritt aus der verlagerbaren Beleuchtungswinkel-Variationseinheit 14b.

Die verlagerbare Beleuchtungswinkel-Variationseinheit 14b ist mittels eines Verlagerungsantriebs 30 um die optische Achse 2 der Beleuchtungsoptik des Beleuchtungssystems 5 drehbar bzw. schwenkbar ausgeführt, wie in der Fig. 4 anhand eines Richtungspfeils 31 schematisch dargestellt ist.

Über den Verlagerungsantrieb 30 kann die verlagerbare Beleuchtungswinkel-Variationseinheit 14b um die optische Achse 2 um mindestens 90° verschwenkt werden.

Fig. 3 zeigt eine Relativposition der beiden Beleuchtungswinkel-Variationseinheiten 14a, 14b zueinander, bei der die verlagerbare Beleuchtungswinkel-Variationseinheit 14b um 90° um die optische Achse 2 im Vergleich zur Relativposition nach Fig. 2 verschwenkt ist. In der Relativposition nach Fig. 3 verläuft die Dachkante 28, die in der Fig. 3 nicht sichtbar ist, also parallel zur x-Achse.

In der Ablenkebene xz, also in der Zeichenebene der Fig. 3, ist in der Relativposition nach Fig. 3 die verlagerbare Beleuchtungswinkel-Variationseinheit 14b wirkungslos, führt in dieser Ablenkebene xz also zu keiner Ablenkung des Beleuchtungslichtstrahls 8. Entsprechend hat der Beleuchtungslichtstrahl 8 nach Durchtritt durch die Beleuchtungswinkel-Variationseinrichtung 14 in der Relativposition nach Fig. 3 in der Ablenkebene xz einen Ablenkwinkel, der dem Ablenkwinkel zwischen den beiden Beleuchtungswinkel-Variationseinheit 14a, 14b entspricht. Da die für die Ablenkung schwächende Wirkung der verlagerbaren Beleuchtungswinkel-Variationseinheit 14b in der Relativposition nach Fig. 3 entfällt, ist die ablenkende Wirkung der statischen Beleuchtungswinkel-Variationseinheit 14a in der Relativposition nach Fig. 3 in der Ablenkebene xz also stärker als in der Relativposition nach Fig. 2. Dieses Ablenkverhalten ist in der Fig. 5 dargestellt.

Zwischen der maximal ablenkenden Wirkstellung der verlagerbaren Beleuchtungswinkel-Variationseinheit 14b nach Fig. 2 und der Neutralstellung der verlagerbaren Beleuchtungswinkel-Variationseinheit 14b nach Fig. 3 sind alle möglichen Zwischen-Ablenkwirkungen der verlagerbaren Beleuchtungswinkel-Variationseinheit 14b in der Ablenkebene xz stufenlos einstellbar. Hierzu wird die verlagerbare Beleuchtungswinkel-Variationseinheit 14b mithilfe des Verlagerungsantriebs 30, beispielsweise ausgehend von der Relativposition nach Fig. 2 um einen Winkel im Bereich zwischen 0° und 90° um die optische Achse 2 verschwenkt.

In der Fig. 1 ist schematisch noch eine Messeinrichtung 32 zur Vermessung eines Beleuchtungsparameters des Beleuchtungslichts, also des Beleuchtungslichtstrahls 8, über das Beleuchtungsfeld 3 dargestellt. Mit der Messeinrichtung 32 kann beispielsweise eine Vermessung des Beleuchtungsparameters abhängig von einer eingestellten Beleuchtungswinkelverteilung über das Beleuchtungsfeld 3, also abhängig von einem eingestellten Beleuchtungssetting, vermessen werden. Alternativ oder zusätzlich kann mit der Messeinrichtung 32 ein Beleuchtungsparameter abhängig von zeitlichen Drifteffekten der Projektionsbelichtungsanlage 1 vermessen werden.

Als zu vermessender Beleuchtungsparameter dient beispielsweise ein Telezentriewert T in Abhängigkeit von einer Beleuchtungsfelddimension x senkrecht zur Scanrichtung y. Die Beleuchtungsfelddimension x senkrecht zur Scanrichtung y ist auch als Feldhöhe bezeichnet.

Der Telezentriewert T ist für ein gegebenes Beleuchtungssetting folgendermaßen definiert:

$$T(x) = \frac{\sum_{n=1}^{N}(I_n(x) \cdot \vec{p}_n)}{r_{NA}\sum_{n=1}^{N}I_n(x)}$$

Hierbei bezeichnen:

n: Nummer des jeweils betrachteten Beleuchtungspols des Beleuchtungssettings;

N: Anzahl der Beleuchtungspole des betrachteten Beleuchtungssettings;

$I_n(x)$: Intensität des Beleuchtungspols n am Feldort x (Feldhöhe). Diese Intensität ist die Gesamtintensität nach Integration über die Scan- bzw. Objektverlagerungsrichtung y über das Beleuchtungsfeld 3 bzw. ein Bildfeld in der Waferebene 22;

$\vec{p}_n(x)$ :Durchstoßpunkt eines Strahlbündels des Beleuchtungspols n am Feldort x durch eine Pupillenebene des Beleuchtungssystems. Dieser Vektor ist dementsprechend zweidimensional.

$r_{NA}$:Radius der Pupillenblende in der oben betrachteten Pupillenebene.

Bei dem Telezentriewert T handelt es sich um eine energetische Telezentrie. T(x) stellt ein Maß für den gesamten Schwerstrahl der Beleuchtung, die mehrere Beleuchtungspole umfasst, abhängig von einer Feldposition x dar.

Die Messeinrichtung 32 steht in nicht näher dargestellter Weise über eine Steuer-/Regeleinheit 33 mit dem Verlagerungsantrieb 30 in Signalverbindung. Als Telezentrie-Messeinrichtung kann eine Messeinrichtung genutzt werden, die beispielsweise bekannt ist aus der DE 10 2005 026 628 A1 oder der DE 10 2007 055 096 A1.

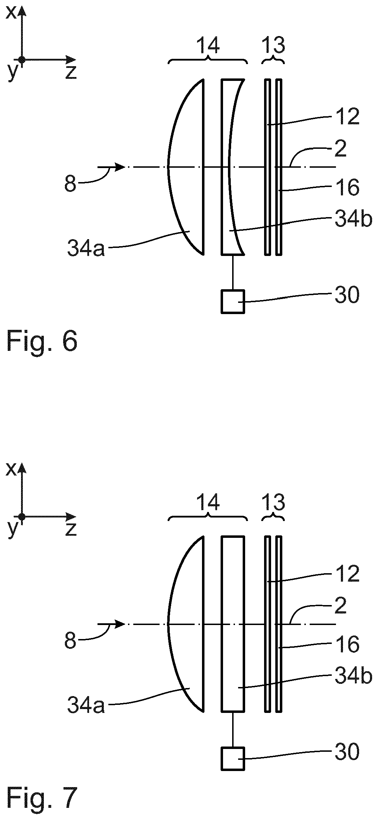

Anhand der Fig. 6 und 7 wird nachfolgend eine weitere Ausführung für die Beleuchtungswinkel-Variationseinrichtung 14 erläutert. Komponenten, die denjenigen entsprechen, die vorstehend unter Bezugnahme auf die Fig. 1 bis 5 bereits diskutiert wurden, tragen die gleichen Bezugsziffern und werden nicht nochmals im Einzelnen erläutert.

Eine statische Beleuchtungswinkel-Variationseinheit 34a, die anstelle der Beleuchtungswinkel-Variationseinheit 14a zum Einsatz kommen kann, ist bei der Ausführung nach den Fig. 6 und 7 als plankonvexe Zylinderlinse mit konvexer Eintrittsfläche und planer Austrittsfläche für den Beleuchtungsstrahl 8 ausgeführt. Eine verlagerbare Beleuchtungswinkel-Variationseinheit 34b, die anstelle der Beleuchtungswinkel-Variationseinheit 14b eingesetzt werden kann, ist als plankonkave Zylinderlinse mit planer Eintrittsfläche und konkaver Austrittsfläche ausgeführt. Die konvexe Eintrittsfläche der Beleuchtungswinkel-Variationseinheit 34a hat eine angenähert elliptische Form. Die konkave Austrittsfläche der Beleuchtungswinkel-Variationseinheit 34b hat eine angenähert elliptische Form. Anstelle einer elliptischen Form ist auch eine andere Formgebung der statischen Beleuchtungswinkel-Variationseinheit 34a und/oder der verlagerbaren Beleuchtungswinkel-Variationseinheit 34b möglich. In der Ebene senkrecht zur Zylinderachse können die Ein- bzw. Austrittsflächen sphärisch, asphärisch oder als Freiformflächen, also als eindimensionale Freiformflächen, gestaltet sein.

Ein Krümmungsradius der konvexen Eintrittsfläche der Beleuchtungswinkel-Variationseinheit 34a ist im Bereich der optischen Achse 2 kleiner als ein Krümmungsradius der konkaven Austrittsfläche der Beleuchtungswinkel-Variationseinheit 14b, ebenfalls im Bereich der optischen Achse 2. Insgesamt hat die verlagerbare Beleuchtungswinkel-Variationseinheit 34b eine kleinere refraktive ablenkende Wirkung auf den Beleuchtungslichtstrahl 8 als die statische Beleuchtungswinkel-Variationseinheit 34a. Bei einer nicht dargetstellten Variante hat die verlagerbare Beleuchtungswinkel-Variationseinheit 34b eine größere refraktive ablenkende Wirkung auf den Beleuchtungslichtstrahl 8 als die statische Beleuchtungswinkel-Variationseinheit 34a.

Aufgrund der konvexen Form der Eintrittsfläche der Beleuchtungswinkel-Variationseinheit 34a ist deren ablenkende Wirkung auf die parallel einfallenden Einzelstrahlen des Beleuchtungsstrahls 8 umso größer, je weiter diese Einzelstrahlen von der optischen Achse 2 entfernt auf die Beleuchtungswinkel-Variationseinheit 34a einfallen. Entsprechendes gilt für die verlagerbare Beleuchtungswinkel-Variationseinheit 34b.

Fig. 6 zeigt die beiden Beleuchtungswinkel-Variationseinheiten 34a, 34b in einer Relativposition, die derjenigen der beiden Beleuchtungswinkel-Variationseinheit 14a, 14b in der Ausführung nach Fig. 2 entspricht. Die verlagerbare Beleuchtungswinkel-Variationseinheit 34b schwächt in dieser Relativposition die Ablenkwinkel, die von der statischen Beleuchtungswinkel-Variationseinheit 34a erzeugt werden, ab.

Fig. 7 zeigt wiederum die Relativposition zwischen den beiden Beleuchtungswinkel-Variationseinheiten 34a, 34b, in der die verlagerbare Beleuchtungswinkel-Variationseinheit 34b um die optische Achse 2 mithilfe des Verlagerungsantriebs 30 um 90° verschwenkt ist. In der in Fig. 7 dargestellten Neutralstellung ist die Beleuchtungswinkel-Variationseinheit 34b in der Ablenkebene xz wirkungslos.

Die Beleuchtungswinkel-Variationseinheiten 14a, 14b bzw. 34a, 34b können in ihrer Reihenfolge, in der sie den Beleuchtungslichtstrahl 8 beeinflussen, auch vertauscht angeordnet sein. Dies ist in der Fig. 1 schematisch angedeutet, wo die Bezugzeichenvergabe so ist, dass sowohl eine Reihenfolge 14a, 14b als auch eine Reihenfolge 14b, 14a für die Anordnung der Beleuchtungswinkel-Variationseinheiten innerhalb der Beleuchtungswinkel-Variationseinrichtung 14 angegeben ist.

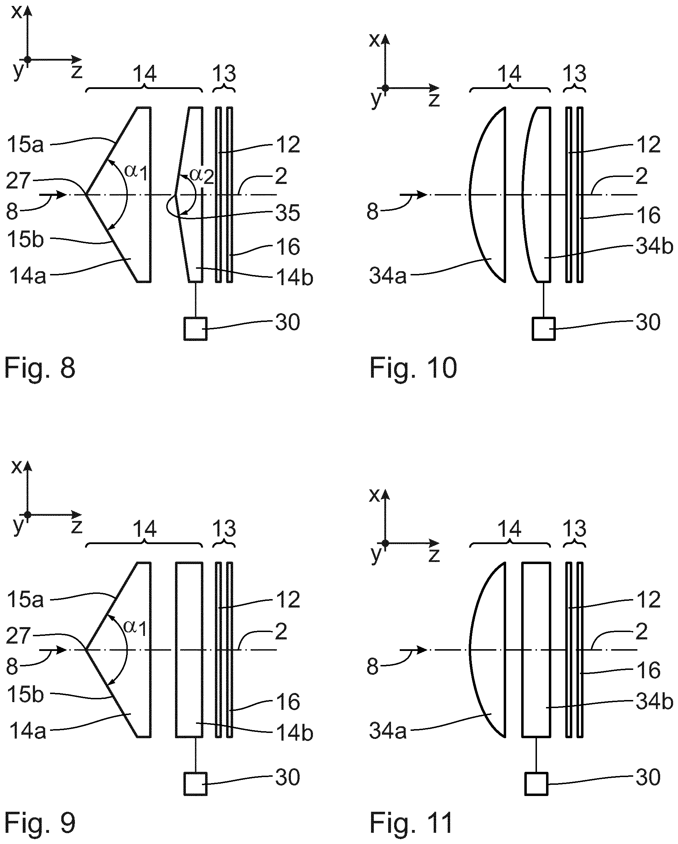

Anhand der Fig. 8 und 9 wird nachfolgend eine weitere Ausführung einer Beleuchtungswinkel-Variationseinrichtung 14 erläutert. Komponenten und Funktionen, die denjenigen entsprechen, die vorstehend unter Bezugnahme auf die Fig. 1 bis 7 und insbesondere unter Bezugnahme auf die Fig. 1 bis 5 bereits erläutert wurden, tragen die gleichen Bezugsziffern und werden nicht nochmals im Einzelnen diskutiert.

Bei der Ausführung nach den Fig. 8 und 9 ist die verlagerbare Beleuchtungswinkel-Variationseinheit 14b ebenfalls, wie die Beleuchtungswinkel-Variationseinheit 14a, als Dachkanten-Prisma mit konvexer Eintrittsfläche mit Dachkante 35 ausgeführt. Ein Dachkantenwinkel $\alpha_1$ zwischen den aneinander angrenzenden Eintrittsflächenabschnitten der Beleuchtungswinkel-Variationseinheit 14a nach den Fig. 8 und 9 ist kleiner als der Dachkanten-Winkel $\alpha_2$ der Beleuchtungswinkel-Variationseinheit 14b. Entsprechend hat die Beleuchtungswinkel-Variationseinheit 14b nach den Fig. 8 und 9 eine geringere refraktive ablenkende Wirkung auf den Beleuchtungslichtstrahl 8 als die statische Beleuchtungswinkel-Variationseinheit 14a. Diese ablenkende Wirkung ist im Unterschied zur ablenkenden Wirkung der Beleuchtungswinkel-Variationseinheit 14b nach den Fig. 1 bis 5 in der Relativposition nach Fig. 8, in der die beiden Dachkanten 27, 35 parallel zueinander verlaufen, verstärkend. Ein Ablenkwinkel eines Einzelstrahls des Beleuchtungslichts 8 ist in der Relativposition nach Fig. 8 nach der Beleuchtungswinkel-Variationseinheit 14b also größer als zwischen den beiden Beleuchtungswinkel-Variationseinheiten 14a, 14b.

Fig. 9 zeigt wiederum eine Neutralstellung der Beleuchtungswinkel-Variationseinheit 14b, in der diese im Vergleich zur Relativposition nach Fig. 8 um 90° um die optische Achse 2 mithilfe des Verlagerungsantriebs 30 verschwenkt ist.

Anhand der Fig. 10 und 11 wird nachfolgend eine weitere Ausführung einer Beleuchtungswinkel-Variationseinrichtung 14 erläutert. Komponenten und Funktionen, die denjenigen entsprechen, die vorstehend unter Bezugnahme auf die Fig. 1 bis 9 und insbesondere unter Bezugnahme auf die Fig. 1 bis 7 bereits erläutert wurden, tragen die gleichen Bezugsziffern und werden nicht nochmals im Einzelnen diskutiert.

Bei der Ausführung nach den Fig. 10 und 11 ist die verlagerbare Beleuchtungswinkel-Variationseinheit 34b genauso wie die statische Beleuchtungswinkel-Variationseinheit 34a als plankonvexe Zylinderlinse mit konvexer Eintrittsfläche und planer Austrittsfläche ausgeführt. Ein Krümmungsradius der verlagerbaren Beleuchtungswinkel-Variationseinheit 34b ist größer als ein Krümmungsradius der statischen Beleuchtungswinkel-Variationseinheit 34a. Für einen Einzelstrahl des Beleuchtungslichtstrahls 8, der parallel zur optischen Achse 2 mit einem positiven Abstand zur optischen Achse 2 auf die Beleuchtungswinkel-Variationseinrichtung 14 nach Fig. 10 auftrifft, hat die statische Beleuchtungswinkel-Variationseinheit 34a also eine stärker ablenkende brechende Wirkung als die verlagerbare Beleuchtungswinkel-Variationseinheit 34b.

Fig. 10 zeigt die Beleuchtungswinkel-Variationseinrichtung 14 mit den Beleuchtungswinkel-Variationseinheiten 34a, 34b in der die ablenkenden Wirkungen in der Ablenkebene xz verstärkenden Relativposition.

Fig. 11 zeigt die Relativposition mit der verlagerbaren Beleuchtungswinkel-Variationseinheit 34b in der Neutralstellung.

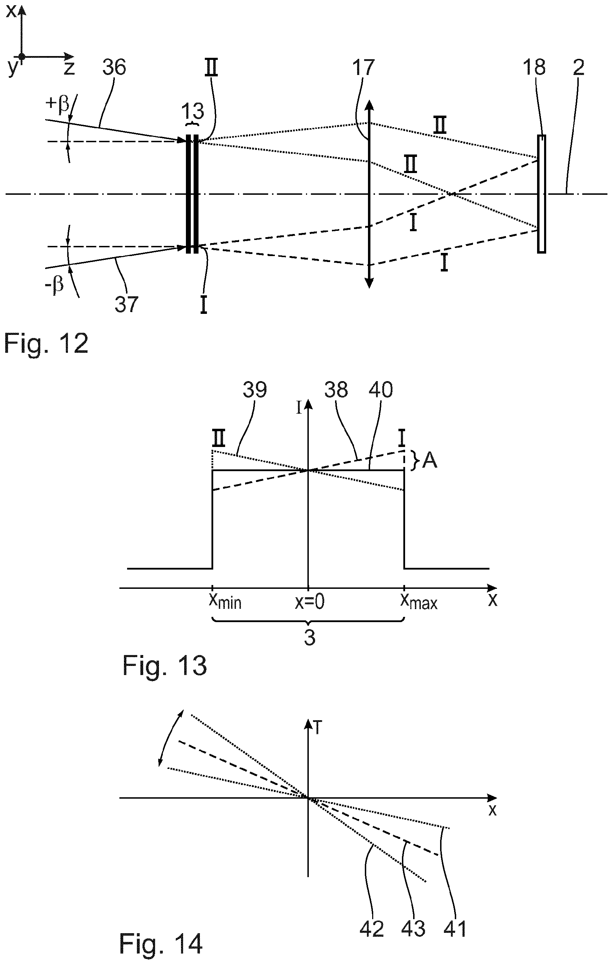

Anhand der Fig. 12 bis 14 wird die Einstellmöglichkeit des Beleuchtungsparameters Telezentrie mithilfe der Beleuchtungswinkel-Variationseinrichtung 14 am Beispiel der Ausführung nach den Fig. 1 bis 5 erläutert. Aufgrund der ablenkenden Wirkung der Beleuchtungswinkel-Variationseinrichtung 14 trifft ein in der Fig. 12 oberer Einzelstrahl 36 auf das Rastermodul 13 mit einem beispielsweise positiven Ablenkwinkel $\beta$ gegenüber der z-Achse und ein in Fig. 12 unten dargestellter Einzelstrahl 37 trifft auf das Rastermodul 13 mit einem hierzu spiegelbildlichen negativen Ablenkwinkel $\beta$ zur z-Achse, also zur optischen Achse 2, auf das Rastermodul 13. Diese Ablenkwinkel sind in der Fig. 12 als $+\beta$ und $-\beta$ eingezeichnet.

Der Einzelstrahl 36 sorgt für eine Beleuchtung in der Feld-Zwischenebene 18 aus Richtung eines Beleuchtungspols, der in der Fig. 12 mit II bezeichnet ist. Entsprechend sorgt der Einzelstrahl 37 für eine Beleuchtung aus Richtung eines Beleuchtungspols, der in der Fig. 12 mit I bezeichnet ist.

Aufgrund der unterschiedlichen ablenkenden Wirkung $+\beta/-\beta$ ergibt sich für die beiden Pole I, II eine unterschiedliche Beleuchtungsintensität I über die Feldhöhe (Felddimension x), was in der Fig. 13 dargestellt ist. Für den Beleuchtungspol I ergibt sich ein Intensitätsverlauf 38, bei dem die Intensität mit zunehmender Feldhöhe in erster Näherung linear ansteigt. Für den Beleuchtungspol II ergibt sich ein gegenläufiger Intensitätsverlauf 39, bei dem die Beleuchtungsintensität mit zunehmender Feldhöhe abfällt. Da die beiden Intensitätsverläufe 38, 39 den gleichen Steigungsbetrag haben, ergibt sich ein Gesamt-Intensitätsverlauf 40, der von der Feldhöhe unabhängig ist.

Gemessen werden die Intensitätsverläufe 38 bis 40 über die gesamte Feldhöhe des Beleuchtungsfeldes 3. Ein Intensitätsunterschied A am Feldrand ($x = X_{min}$ oder $x = x_{max}$) zu einer Intensität in der Feldmitte ($x = 0$) wird als Amplitude A des Feldverlaufes bezeichnet. Es gilt:

$$A = \left| \; I(x=0) - I(x_{\min/\max}) \; \right|$$

Aufgrund der Intensitätsverläufe 38, 39 ergibt sich abhängig vom Ablenkwinkel $\beta$ ein Telezentrieverlauf, der in der Fig. 14 dargestellt ist. Beim Ablenkwinkel +/-$\beta$ nach Fig. 12, der der Relativposition der Beleuchtungswinkel-Variationseinheiten 14a, 14b nach Fig. 2 entspricht, ergibt sich ein Telezentrieverlauf 41 mit minimaler Steigung über die Feldhöhe. In der Neutralstellung nach Fig. 3, in der ein maximaler Ablenkwinkel $\beta$ erzeugt werden kann, ergibt sich ein Telezentrieverlauf 42 mit maximaler Steigung über die Feldhöhe. Bei einer Zwischenstellung der verlagerbaren Beleuchtungswinkel-Variationseinheit 14b zwischen den Positionen nach den Fig 2 und 3 ergibt sich ein mittlerer Telezentrie-Verlauf 43 mit mittlerer Steigung über die Feldhöhe. Je nach der Schwenkposition der verlagerbaren Beleuchtungswinkel-Variationseinheit 14b um die optische Achse 2 ergibt sich also ein Telezentrie-Verlauf, der zwischen den Extremal-Telezentrieverläufen 41, 42 stufenlos eingestellt werden kann.

Bei den vorstehend beschriebenen Ausführungen werden mithilfe der Beleuchtungswinkel-Variationseinheiten 14a, 14 b bzw. 34a, 34b Ablenkwinkel +/-$\beta$ in der Ablenkebene xz mit gleichem Absolutbetrag erzeugt. In den Winkelvariationsabschnitten, die den Dachflächen 15a, 15b der Ausführung nach den Fig. 1 bis 5 entsprechen, können aber auch unterschiedliche absolute Ablenkwinkel erzeugt werden. Die absoluten Neigungen der Dachflächen der Dachkanten-Prismen, die vorstehend im Zusammenhang mit den verschiedenen Ausführungen beschrieben wurden, können also voneinander abweichen.

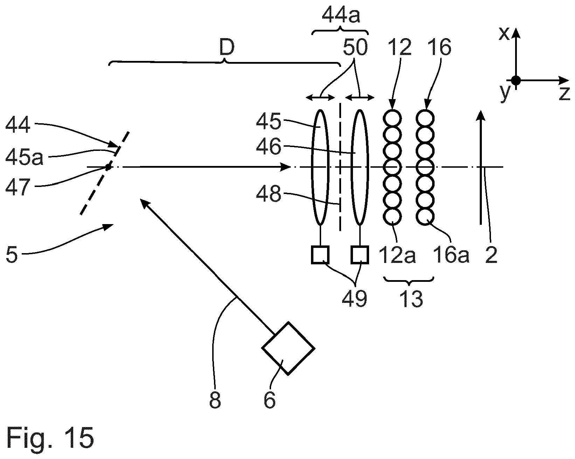

Anhand der Fig. 15 bis 18 wird nachfolgend eine weitere Ausführung einer Beleuchtungswinkel-Variationseinrichtung 44a als Bestandteil einer weiteren Ausführung einer Beleuchtungsoptik für die Projektionsbelichtungsanlage 1 nach Fig. 1 erläutert. Komponenten und Funktionen, die denjenigen entsprechen, die vorstehend unter Bezugnahme auf die Fig. 1 bis 14 bereits erläutert wurden, tragen die gleichen Bezugsziffern und werden nicht nochmals im Einzelnen diskutiert. In der schematischen Darstellung nach Fig. 15 sind die Rasterelemente 12a, 16a der Rasteranordnungen 12, 16 rund dargestellt.

Die Beleuchtungsoptik nach Fig. 15 hat anstelle des diffraktiven optischen Elements 9 ein Mikrospiegelarray (multi-mirror array, MMA) 44. Das MMA 44 hat eine Vielzahl von unabhängig voneinander verkippbaren Einzelspiegeln 45a. Mit den Einzelspiegeln 45a wird der BeleuchtungslichtStrahl 8, der auf das MMA 44 einfällt, in eine Vielzahl von Teilbündeln aufgeteilt und am Ort der ersten Rasteranordnung 12 des Rastermoduls 13 eine vorgegebene Intensitätsverteilung erzeugt. Das Rastermodul 13 setzt diese Intensitätsverteilung dann in eine Beleuchtungswinkelverteilung zunächst in der Feld-Zwischenebene 18 (vgl. Fig. 1) und später im Objektfeld 3 um. Mit dem MMA 44 lässt sich also ein Beleuchtungssetting des Beleuchtungssystems 5 nach Fig. 15 erzeugen. Die optische Achse 2 ist definiert als Verbindungsachse zwischen einem Zentrum 47 des MMA 44 und einem Zentrum einer Apertur des Rastermoduls 13. In Bezug auf weitere Details dieser MMA-Ausführung eines Beleuchtungssystems wird auf die WO 2011/157601 A2 verwiesen.

Die Beleuchtungsoptik nach Fig. 15 hat zwischen dem MMA 44 und dem Rastermodul 13 die Beleuchtungswinkel-Variationseinrichtung 44a in Form eines Pupillenlinsen-Moduls. Dieses umfasst zwei Pupillenlinsen 45, 46 mit Brennweiten $f_1$ und $f_2$. Eine kombinierte Brennweite f des Pupillenlinsen-Moduls 44a nach Fig. 15 ergibt sich zu

$$f = \frac{f_1 f_2}{f_1 + f_2 - e}$$

$e$ ist dabei der Abstand zwischen den beiden Pupillenlinsen 45, 46.

Die effektive Brennweite f lässt sich durch Variation des Abstandes $e$ variieren zwischen zwei Brennweiten $f_{min}$ und $f_{max}$, wobei gilt: $f_{min} < D < f_{max}$, wobei D der Abstand ist zwischen dem Zentrum 47 des MMA 44 und einer optischen Hauptebene 48 des Pupillenlinsen-Moduls 44a.

Zur Vorgabe des Abstandes $e$ sind die Pupillenlinsen 45, 46 jeweils mit einem Verlagerungsaktor 49 verbunden, die eine Verlagerung der Pupillenlinsen 45, 46 unabhängig voneinander längs der optischen Achse 2 (vgl. Doppelpfeile 50 in der Fig.15) bewirken. Alternativ ist es möglich, nur eine der beiden Pupillenlinsen 45, 46 mit einem entsprechenden Verlagerungsaktor 49 auszurüsten.

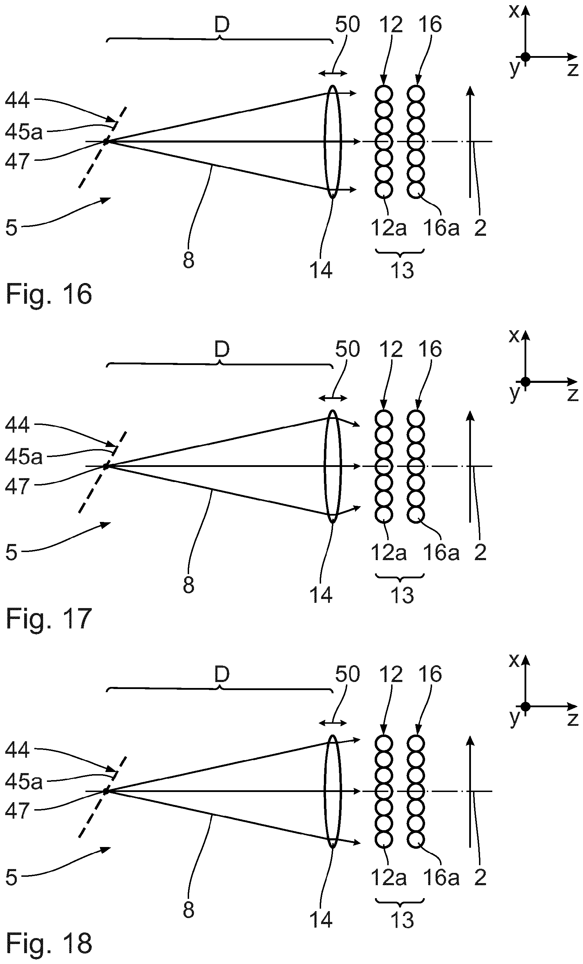

Die Fig. 16 bis 18 zeigen die drei prinzipiellen Brennweiten-Einstellungen des Pupillenlinsen-Moduls 44a. Letzteres ist in den Fig. 16 bis 18 schematisch als eine einzige Linse dargestellt.

Fig. 16 verdeutlicht die Situation, bei der die effektive Brennweite f des Pupillenlinsen-Moduls 44a gleich dem Abstand D zwischen der Hauptebene 48 dieses Moduls und dem Zentrum 47 des MMA 44 ist. Es gilt also f = D. Vom Zentrum 47 des MMA 44 ausgehende Strahlung 8 wird vom Pupillenlinsen-Modul 44a so umgelenkt, dass sie parallel zur z-Richtung auf das Rastermodul 13 auftrifft. Der Ablenkwinkel $\beta$ ist dann also $\beta = 0$.

Fig. 17 verdeutlicht die Situation "f < D". Die Beleuchtungsstrahlung 8 wird vom Pupillenlinsen-Modul 44a konvergent auf das Rastermodul 13 gelenkt. Es ergeben sich Ablenkwinkel +β und -β, die qualitativ dem entsprechen, was vorstehend in Bezugnahme auf die Fig. 12 bereits erläutert wurde.

Fig. 18 zeigt die Situation "f>D". Das Pupillenlinsen-Modul 44a lenkt die Strahlung 8 dann divergent auf das Rastermodul 13. Es ergeben sich dann genau umgekehrte Ablenkwinkel -β/+β als in der Situation, die vorstehend im Zusammenhang mit der Fig. 12 erläutert wurde.

Mit den Einstellungen "f<D" und "f>D" lässt sich ein vom Ort einer Beleuchtungspupille, also beispielsweise von der Position eines Beleuchtungs-Pols abhängiger Offset eines Beleuchtungswinkels β vorgeben. Hinzu kann ein Ablenkwinkel-Beitrag kommen, der vom Ort des die jeweilige Pol-Beaufschlagung herbeiführenden Einzelspiegels 45a auf dem MMA 44 herrührt. Über eine Kombination des von der Einstellung der jeweiligen Situation "f=D", "f<D" und "f>D" abhängigen Ablenkwinkel-Offsets und der Ortsauswahl der für die jeweilige Pupillenausleuchtung herangezogenen Einzelspiegels 45a lässt sich also ein Ablenkwinkel und damit eine Feldabhängigkeit einer Beleuchtungsintensität aus einer bestimmten Beleuchtungsrichtung einstellen. Dies kann insbesondere zu Kompensationszwecken für den Beleuchtungsparameter "Telezentrie" genutzt werden.

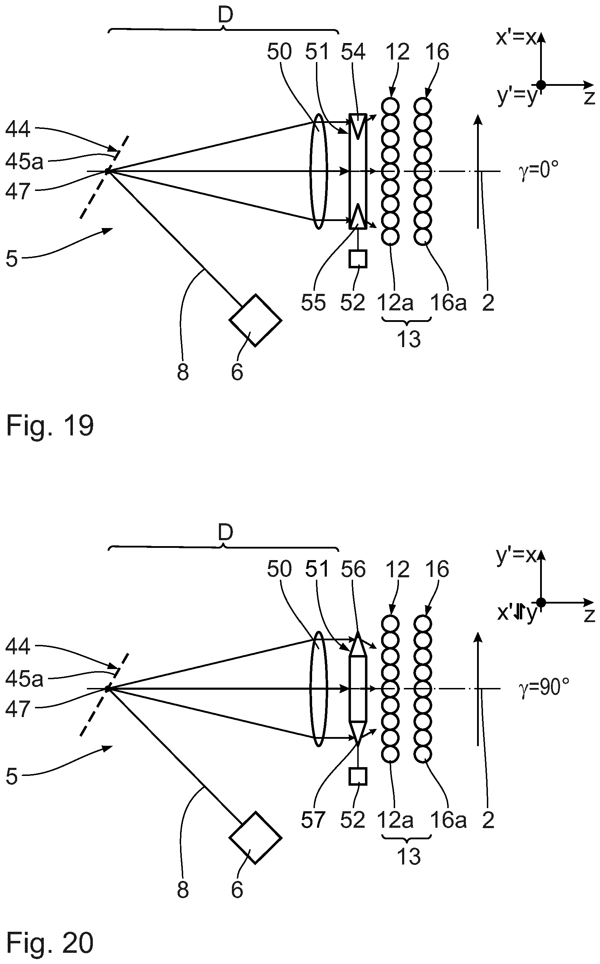

Anhand der Fig. 19 bis 27 wird nachfolgende eine weitere Ausführung einer Beleuchtungswinkel-Variationseinrichtung 51 erläutert. Komponenten und Funktionen, die denjenigen entsprechen, die vorstehend unter Bezugnahme auf die Fig. 1 bis 18 und insbesondere unter Bezugnahme auf die Fig. 15 bis 18 bereits erläutert wurden, tragen die gleichen Bezugsziffern und werden nicht nochmals im Einzelnen diskutiert.

Beim Beleuchtungssystem 5 nach Fig. 19 ist im Strahlengang zwischen dem MMA 44 und dem Rastermodul 13 zunächst eine Pupillenlinse 50 angeordnet. Für deren Brennweite f gilt: f = D.

Zwischen der Pupillenlinse 50 und dem Rastermodul 13 ist die Beleuchtungswinkel-Variationseinrichtung 51 in Form einer verlagerbaren Beleuchtungswinkel-Variationseinheit angeordnet. Die Beleuchtungswinkel-Variationseinheit 51 steht mit einem Verlagerungsaktor 52 in Wirkverbindung. Mit dem Verlagerungsaktor 52 kann die Beleuchtungswinkel-Variationseinheit 51 um die optische Achse 2 verschwenkt werden.

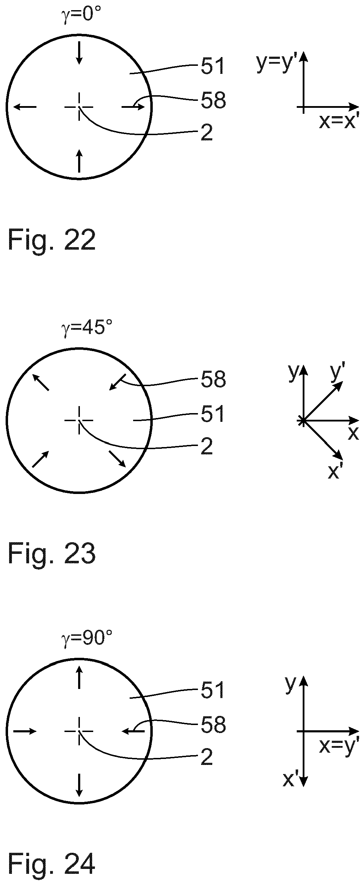

In den Fig. 19, 20 sowie 22 bis 25 ist neben dem globalen kartesischen xyz-Koordinatensystem noch ein lokales kartesisches x'y'-Koordinatensystem der Beleuchtungswinkel-Variationseinheit 51 eingezeichnet, welches die Schwenkposition der Beleuchtungswinkel-Variationseinheit 51 um die optische Achse 2 verdeutlicht. Die Fig. 19 und 22 zeigen die Beleuchtungswinkel-Variationseinheit 51 in einer Schwenkposition y = 0°, bei der die x-Achse mit der x'-Achse und die y-Achse mit der y'-Achse zusammenfällt. Die Fig. 20 und 24 zeigen die Beleuchtungswinkel-Variationseinheit 51 in der Schwenkposition y = 90°, bei der die x-Achse mit der y'-Achse zusammenfällt und die y-Achse und die x'-Achse zueinander antiparallel sind.

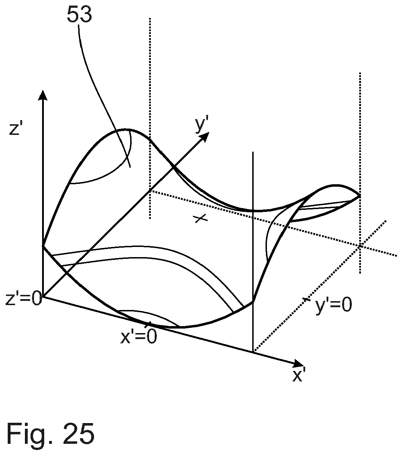

Fig. 25 zeigt in einer perspektivischen Darstellung eine brechende Oberfläche, beispielsweise eine Eintrittsfläche 53 der Beleuchtungswinkel-Variationseinheit 51. Die Austrittsfläche ergibt sich dann durch Spiegelung der Eintrittsfläche 53 um die x'y'-Ebene am Ort z' = 0 (z = z'). Die Beleuchtungswinkel-Variationseinheit 51 stellt also eine Doppel-Sattelkörper-Komponente oder Sattelflächen-Komponente dar. Es ist ebenfalls möglich, entweder die Eintrittsfläche 53 der Beleuchtungswinkel-Variationseinheit 51 oder die Austrittsfläche der Beleuchtungswinkel-Variationseinheit eben auszuführen. In der x'z'-Ebene (y' = 0) betrachtet, hat die Sattelflächen-Komponente 51 in etwa die Form eines Doppelkeils mit sich zu positiven x'-Werten einerseits und zu negativen x'-Werten andererseits öffnenden Keilen 54, 55, wie in der Fig. 19 schematisch dargestellt. In der y'z'-Ebene (wenn x' = 0) hat die Sattelflächen-Komponente 51 wiederum die Form zweier sich zum Rand jeweils hin schließender Keile 56, 57, wie in der Fig. 20 angedeutet.

Eine brechende Wirkung und damit eine Ablenkwinkel-erzeugende Wirkung der Beleuchtungswinkel-Variationseinheit 51 ist in den Fig. 22 bis 24 durch Richtungspfeile 58 dargestellt.

In der Stellung nach Fig. 22 wird einerseits in positiver x-Richtung und andererseits in negativer x-Richtung durch die Abschnitte der Sattelflächen-Komponente 51 mit den Keilen 54, 55 eine in Bezug auf die optische Achse 2 radial nach außen wirkende Ablenkung erzeugt, also in der xz-Ebene eine ablenkende Wirkung, die derjenigen nach Fig. 18 entspricht. In der yz-Ebene wird in der Relativposition nach den Fig. 19 und 22 hingegen eine ablenkende Wirkung radial nach innen, also jeweils zur optischen Achse 2 hin, also eine der Fig. 17 entsprechende ablenkende Wirkung erzielt. Durch Drehung der Beleuchtungswinkel-Variationseinheit 51 um die optische Achse 2 um den Drehwinkel y lässt sich die ablenkende Wirkung insbesondere in der x-Richtung, also in der xz-Ablenkebene, variieren.

Fig. 23 zeigt dabei im Grenzfall γ = 45° eine in der x-Richtung neutrale Ablenkwirkung, da sich im Übergangsbereich zwischen den Abschnitten der Keile 54 und 56 einerseits und 55 und 57 andererseits die ablenkenden Wirkungen radial nach außen und radial nach innen gerade aufheben.

Fig. 24 zeigt die Schwenkposition γ = 90°. Hier sind die Keile 56, 57 nun in der xz-Ebene angeordnet, sodass in der x-Richtung eine ablenkende Wirkung radial nach innen, also zur optischen Achse 2 hin, resultiert, entsprechend der vorstehend in Zusammenhang mit der Fig. 17 beschriebenen Wirkung.

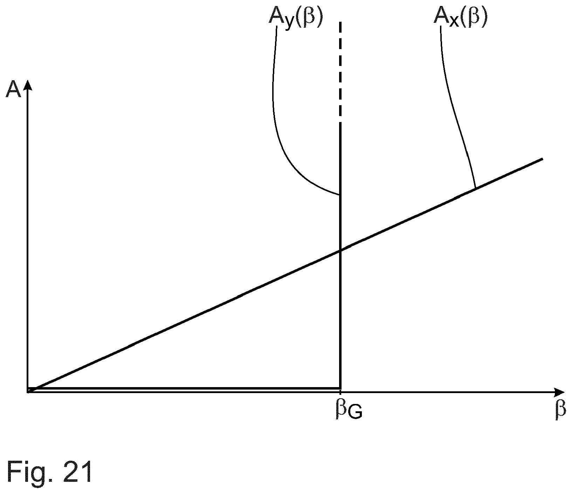

Fig. 21 zeigt die Auswirkungen eines Auftreffwinkels β auf das Rasterelement 13 auf die Amplitude A des Feldverlaufes der Intensität über das Beleuchtungs- bzw. Objektfeld 3, einerseits falls der Winkel β in x-Richtung verläuft, der Strahl so in der x-z-Ebene verläuft, bezeichnet als Kurvenverlauf $A_x(\beta)$, und andererseits für die y-Richtung mit dem

Kurvenverlauf $A_y(\beta)$. Mit zunehmendem Auftreffwinkel $\beta$ nimmt die Amplitude $A_x(\beta)$ des Feldverlaufs der Intensität I (vgl. auch die Ausführungen zu Fig. 13) in der x-Richtung näherungsweise linear zu. In der y-Richtung bleibt eine entsprechende Amplitude $A_y(\beta)$ des Feldverlaufes der Intensität bis einem Grenz-Auftreffwinkel $\beta_G$ unbeeinflusst. Bei der Auslegung der Beleuchtungswinkel-Variationseinheit 51 werden die Keilwinkel der Abschnitte der Sattelflächen-Komponente mit den Keilen 54, 55 einerseits und den Keilen 56, 57 andererseits so ausgelegt, dass dieser maximale Auftreffwinkel $\beta_G$ zumindest in y-Richtung nicht überschritten wird. Zwischen den maximalen Auftreffwinkeln +/-$\beta_G$ kann dann der Auftreffwinkel $\beta$ in der xz-Ablenkebene durch eine Rotation der Beleuchtungswinkel-Variationseinheit 51 zwischen den Winkeln $\gamma = 0$ und $\gamma = 90°$ stufenlos variiert werden. In der y-Richtung bleibt die Amplitude des Feldverlaufs A dann wie erwünscht unbeeinflusst.

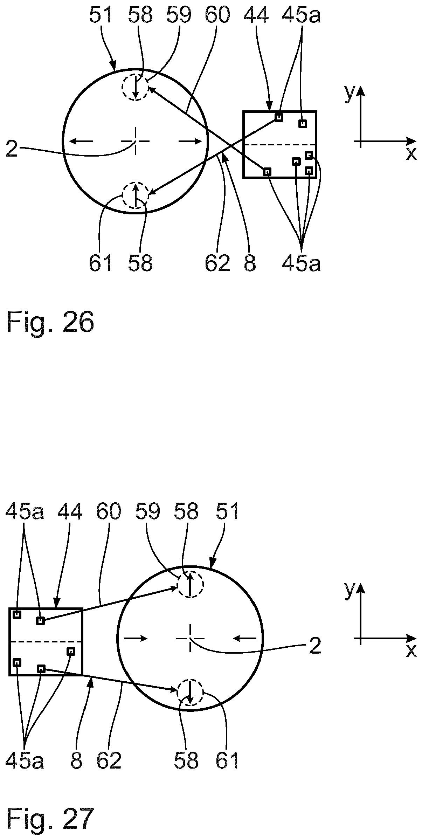

Die Fig. 26 und 27 zeigen verschiedene Beaufschlagungs-Varianten der Beleuchtungswinkel-Variationseinheit 51 über die Einzelspiegel 45a des MMA 44. In den Fig. 26 und 27 sind beispielhaft einige der Einzelspiegel 45a des MMA 44 angedeutet.

Dargestellt sind in den Fig. 26 und 27 sowohl das MMA 44 als auch die Beleuchtungswinkel-Variationseinheit 51 in einer Aufsicht, also jeweils in der Projektion auf xy-Ebene. Tatsächlich sind die Komponenten 44 und 51 nicht nebeneinander, sondern hintereinander angeordnet. Zwischen den Komponenten 44 und 51 befindet sich die Pupillenlinse 50 (vgl. Fig. 19 und 20). Die Pupillenlinse 50 kann auch zwischen der Beleuchtungswinkel-Variationseinheit 51 und dem Rasterelement 13 angeordnet sein. Die optische Wirkung der Pupillenlinse 50 kann auch in die Beleuchtungswinkel-Variationseinheit 51 integriert sein. Für die folgende Beschreibung wird davon ausgegangen, daß die Pupillenlinse sich zwischen den Komponenten 44 und 51 befindet. Die Pfeile in Fig. 26 und zeigen eine Zuordnung von 45a des MMA 44 zu Orten der Beleuchtungswinkel-Variationseinheit 51 und damit näherungsweise zu einer Pupillenebene des Beleuchtungssystems 5. Die entsprechenden Strahlbündel verlaufen auf Grund der Wirkung der Pupillenlinse 50 im allgemeinen nicht entlang einer Geraden. Der Auftreffwinkel auf das Rasterelement 13 hängt sowohl von der relativen Anordnung des betreffenden Einzelspiegels 45a des MMA und dem Auftreffort auf die Beleuchtungswinkel-Variationseinheit 51 als auch vom durch die Beleuchtungswinkel-Variationseinheit verursachten Ablenkwinkel ab.

Fig. 26 zeigt eine Beaufschlagungsvariante "Y-Dipol", bei der ein +Y-Polbereich 59 der Beleuchtungswinkel-Variationseinheit 51 von Einzelspiegel 45a aus einer in Fig. 26 unteren Hälfte des MMA 44 beaufschlagt ist. Ein hierfür beispielhafter Strahlengang eines Einzelstrahls ist in der Fig. 26 durch einen Pfeil 60 angedeutet. Umgekehrt wird ein -Y-Polbereich 61 auf der Beleuchtungswinkel-Variationseinheit 51 über Einzelspiegel 45a aus der in der Fig. 26 oberen Hälfte des MMA 44 beleuchtet, wie in der Fig. 26 für einen Strahlengang durch einen Pfeil 62 angedeutet.

Bei der Beleuchtung nach Fig. 26 liegt die Beleuchtungswinkel-Variationseinheit 51 in der Relativposition "$\gamma = 0°$" nach Fig. 22 vor. In den Y-Polbereichen 59, 61 der Beleuchtungswinkel-Variationseinheit 51 erfolgt eine Ablenkung der Beleuchtungsstrahlung 8 also radial hin zur optischen Achse 2, wie durch die Richtungspfeile 58 in den Y-Polbereichen 59, 61 angedeutet. Die aufgrund der kreuzweisen Zuordnung der Strahlengänge 60, 62 zu den Y-Polbereichen 59, 61 großen, nach außen gerichteten Strahlwinkel der Strahlengänge 60, 62 der Beleuchtungsstrahlung 8 zur optischen Achse 2 werden durch die Wirkung der Bereiche der Sattelflächen-Komponente 51 mit den Keilen 56, 57nach innen umgebogen. Ein Überschreiten des Grenzwinkels $\beta_G$ kann somit vermieden werden.

Fig. 27 zeigt eine Variante der Beleuchtung der Y-Polbereiche 59, 61 in der Stellung der Beleuchtungswinkel-Variationseinheit 51 "$\gamma = 90°$" nach Fig. 24. Der Strahlwinkel in y-Richtung beim Auftreffen auf die Beleuchtungswinkel-Variationseinheit 51 sind klein. Durch die sich im Strahlengang nach der Beleuchtungswinkel-Variationseinheit 51 befindende Pupillenlinse 50 werden die Strahlen nach innen umgebogen, so daß sich ein großer Absolutwert der Auftreffwinkels auf das Rasterelement 13 ergeben kann. Auf der Beleuchtungswinkel-Variationseinheit 51 wirken in den Y-Polbereichen 59, 61 nun die Bereiche der Sattelflächen-Komponente 51 mit den Keilen 54, 55, die zu einer zusätzlichen Ablenkung der Strahlung 8 radial nach außen führen und damit die Wirkung der Pupillenlinse 50 teilweise kompensieren. Bei der Beleuchtung der Y-Polbereiche 59, 61 nach Fig. 27 ist die Zuordnung der Einzelspiegel 45a, die für die Beaufschlagung der Y-Polbereiche 59, 61 sorgen, im Vergleich zur Fig. 26 genau vertauscht. Die absoluten Ablenkwinkel der Einzelstrahlen des Beleuchtungslichtstrahls 8 vom MMA 44 zur Beleuchtungswinkel-Variationseinheit 51 sind somit verringert, sodass die Vergrößerung der Ablenkwinkel durch die Keile 54, 55 in den Y-Polbereichen 59, 61 in der Stellung nach Fig. 27 zu einem hinsichtlich seiner Absolutgröße vertretbaren gesamten Auftreffwinkel führt. Ein Überschreiten des Grenzwinkels $\beta_G$ kann somit vermieden werden.

Insbesondere wird somit eine unerwünscht große Ablenkung in der yz-Ebene, also senkrecht zur xz-Ablenkebene, vermieden.

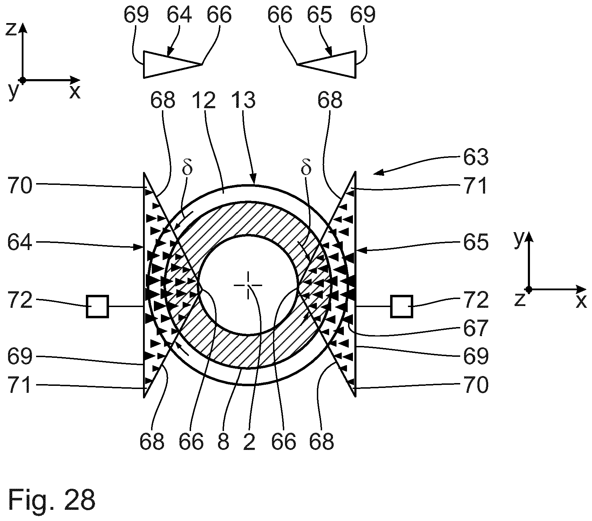

Anhand der Fig. 28 bis 31 werden nachfolgend weitere Ausführungen einer Beleuchtungswinkel-Variationseinrichtung 63 erläutert. Komponenten und Funktionen, die denjenigen entsprechen, die vorstehend unter Bezugnahme auf die Fig. 1 bis 27 bereits erläutert wurden, tragen die gleichen Bezugsziffern und werden nicht nochmals im Einzelnen diskutiert.

Die Beleuchtungswinkel-Variationseinrichtung 63 ist in der Fig. 28 in einer Aufsicht dargestellt, wobei die Blickrichtung, wie z. B. auch in den Fig. 22 bis 24, 26 und 27, längs der optischen Achse 2 verläuft. Dargestellt ist in der Fig. 28 die Beleuchtungswinkel-Variationseinrichtung 63 vor der ersten Rasteranordnung 12 des Rastermoduls 13 am Beispiel einer annularen Beleuchtung dieser ersten Rasteranordnung 12.

Die Beleuchtungswinkel-Variationseinrichtung 63 umfasst zwei in der Aufsicht nach Fig. 28 jeweils keilförmige Beleuchtungswinkel-Variationseinheiten 64, 65. Keilspitzen 66 der Beleuchtungswinkel-Variationseinheiten 64, 65 liegen in der xz-Ebene, in der auch die optische Achse liegt. Ein Apex-Winkel δ der keilförmigen Beleuchtungswinkel-Variationseinheiten 64, 65 beträgt etwa 130°. Auch ein anderer Apex-Winkel im Bereich zwischen 90° und 160° ist möglich.

In der Fig. 28 durch verschieden große Pfeilspitzen 67 ist eine Ablenkwirkung der Beleuchtungswinkel-Variationseinheiten 64, 65 in der xz-Ablenkebene dargestellt. Die Richtung der Pfeilspitze zeigt dabei an, in welche Richtung die Ablenkwirkung erfolgt und die Größe des Pfeils stellt ein Maß für den Betrag dieser ablenkenden Wirkung dar. Benachbart zu den beiden an die Keilspitze 66 jeweils angrenzenden Keilkanten 68 hat diese Ablenkwirkung 67 jeweils den gleichen und relativ kleinen Absolutwert. Mit zunehmendem Abstand zu den Keilkanten 68 nimmt die Ablenkwirkung in der xz-Ablenkebene stetig zu. Dies führt dazu, dass im Bereich einer Keil-Basis 69 der keilförmigen Beleuchtungswinkel-Variationseinheiten 64, 65 die ablenkende Wirkung in einer Basismitte am größten ist und zu den beiden spitzen Seitenecken 70, 71 der Keile stetig abnimmt. Im Bereich der Basismitten ist ein Gradient einer brechenden Oberfläche in der xz-Ebene entsprechend am größten. Im xz-Querschnitt, der in der Fig. 28 oberhalb der Aufsicht dargestellt ist, sind die Beleuchtungswinkel-Variationseinheiten 64, 65 also ebenfalls keilförmig und verjüngen sich jeweils hin zur optischen Achse 2.

In der xy-Ebene betrachtet haben die Keilkanten 68 eine Steigung $|dy/dx|$, die deutlich größer ist als 1 und auch beim dargestellten Beispiel etwa 2 beträgt. Eine räumlich nichtkonstante Ablenkwirkung in horizontaler Richtung führt zu einer unerwünschten Ablenkwirkung. Diese unerwünschte Ablenkwirkung in vertikaler Richtung kann innerhalb akzeptabler Grenzen gehalten werden, wenn die Steigung $|dy/dx|$ hinreichend groß ist.

Die Beleuchtungswinkel-Variationseinheiten 64, 65 nach Fig. 28 sind jeweils mit einem Verlagerungsaktor 72 verbunden, mittels dem die Beleuchtungswinkel-Variationseinheiten 64, 65 längst der x-Richtung verlagerbar, also längs der x-Richtung in den Strahlengang der Beleuchtungsstrahlung 8 ein- bzw. ausfahrbar sind. In der Wirkstellung, die in der Fig. 28 dargestellt ist, ist ein Bereich der keilförmigen Beleuchtungswinkel-Variationseinheiten 64, 65 um die Keilspitzen 66 herum zur Beeinflussung der anularen Ausleuchtung der ersten Rasteranordnung 12 wirksam. Auf-grund der großen Steigung der Keilkanten 68 ergibt sich in einem großen Bereich dieser anularen Beleuchtung ein sanfter Übergang zwischen Strahlung, die von den Beleuchtungswinkel-Variationseinheiten 64, 65 in der xz-Ablenkebene abgelenkt wird, und unabgelenkter Strahlung 8.

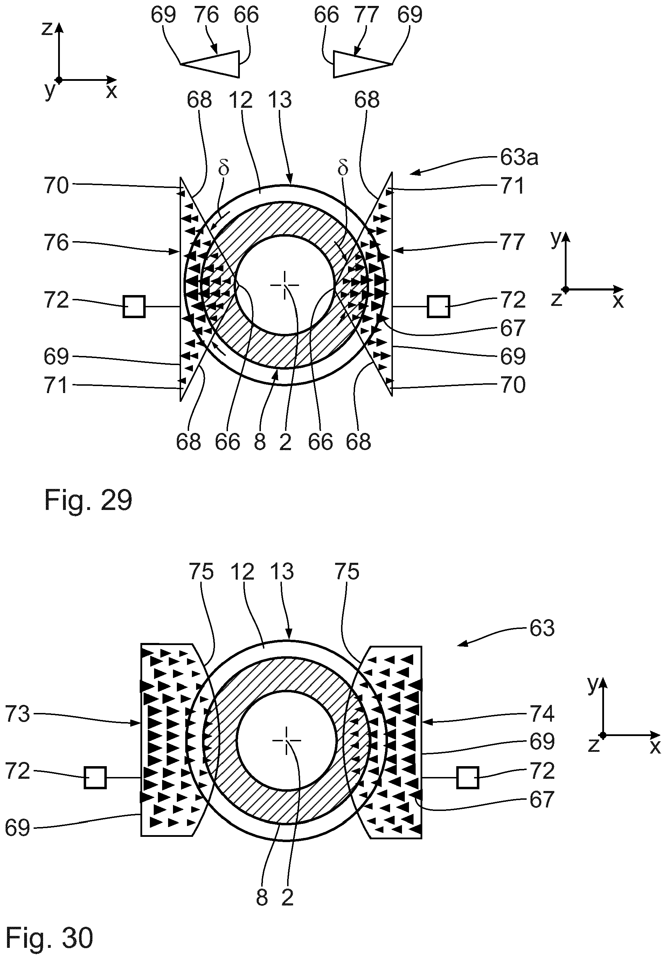

Fig. 29 zeigt in einer zu Fig. 28 ähnlichen Darstellung eine weitere Beleuchtungswinkel-Variationseinrichtung 63a mit zwei Beleuchtungswinkel-Variationseinheiten 76, 77. Komponenten, die vorstehend im Zusammenhang mit der Fig. 28 bereits erläutert wurden, tragen die gleichen Bezugsziffern und werden nicht nochmals im Einzelnen diskutiert. Die Beleuchtungswinkel-Variationseinheiten 76, 77 haben in der Relativposition zum Rastermodul 13, die in der Fig. 29 dargestellt ist, in einer Aufsicht, also in einer xy-Projektion, die gleiche Außenkontur wie die Beleuchtungswinkel-Variationseinheiten 64, 65 nach Fig. 28. Eine ablenkende Wirkung der Beleuchtungswinkel-Variationseinheiten 76, 77 in der xz-Ablenkebene ist genau invers zur ablenkenden Wirkung der Beleuchtungswinkel-Variationseinheiten 64, 65. Dies ist in den Fig. 28 und 29 anschaulich gemacht durch Keildarstellungen jeweils im oberen Bereich der Fig. 28 und 29, die einen xz-Schnitt durch die jeweiligen Beleuchtungswinkel-Variationseinheiten auf Höhe der optischen Achse 2 andeuten. Während bei den Beleuchtungswinkel-Variationseinheiten 64, 65 im xz-Schnitt die Keilspitzen 66 gleichzeitig die in z-Strahlrichtung dünnsten Abschnitte darstellen, ist dies bei den Beleuchtungswinkel-Variationseinheiten 76, 77 genau umgekehrt, wo jeweils die Keil-Basisbereiche 69 am dünnsten sind.

Entsprechend verlaufen die Pfeilspitzen 67, die die ablenkende Wirkung der Beleuchtungswinkel-Variationseinheiten 76, 77 in der xz-Ablenkebene andeuten, nun von den Keilspitzen 66 der Beleuchtungswinkel-Variationseinheiten 76, 77 hin zur jeweiligen Keil-Basis 69.

Fig. 30 zeigt eine abgewandelte Ausführung der Beleuchtungswinkel-Variationseinrichtung 63. Komponenten und Funktionen, die vorstehend im Zusammenhang mit der Fig. 28 bereits erläutert wurden, tragen die gleichen Bezugsziffern und werden nicht nochmals im Einzelnen diskutiert. Beleuchtungswinkel-Variationseinheiten 73, 74 sind mit einem etwa halbmondförmigen Kantenbereich 75 versehen, der eine abgerundete Variante der über die Keilspitze 66 aneinander angrenzenden Keilkanten 68 der Ausführung nach Fig. 28 darstellt. Die Beleuchtungswinkel-Variationseinheiten 73. 74 tauchen über diese halbmondförmigen Kantenbereiche 75 in den Strahlengang der Beleuchtungsstrahlung 8 ein.

Im in der Fig. 30 nicht dargestellten xz-Querschnitt sind die Beleuchtungswinkel-Variationseinheiten 73, 74, wie vorstehend im Zusammenhang mit den Beleuchtungswinkel-Variationseinheiten 64, 65 bereits erläutert, ebenfalls keilförmig und verjüngen sich ebenfalls zur optischen Achse 2 hin.

Die Steigung $|dy/dx|$ ist längs der Kantenbereiche 75 wiederum deutlich größer als 1 und im dargestellten Ausführungsbeispiel dort, wo die Kantenbereiche 75 in die Strahlung 8 eintauchen, auch größer als 2.

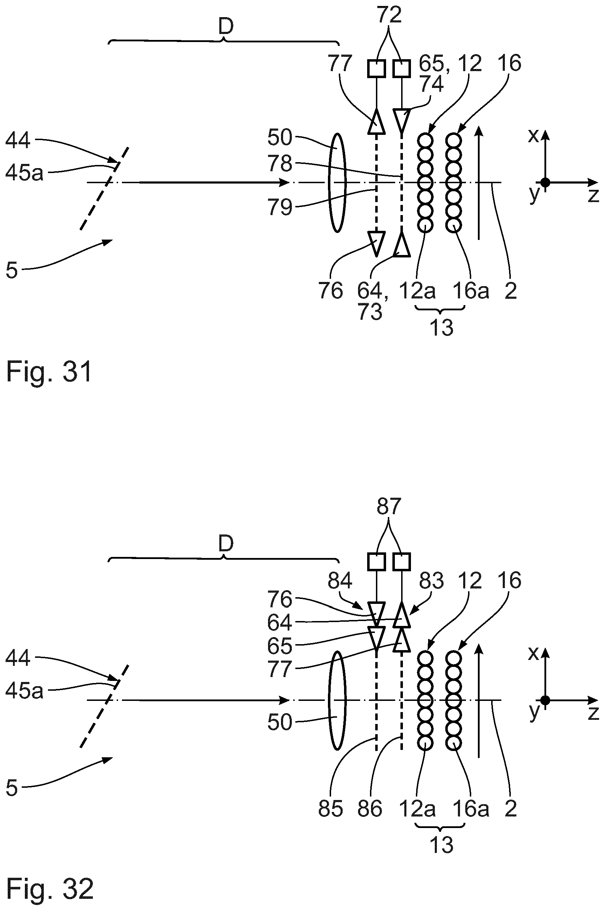

Die Figuren 31 und 32 zeigen verschieden Anordnungsvarianten von keilförmigen Beleuchtungswinkel-Variationseinheiten 64, 65 bzw. 73, 74 zwischen der Pupillenlinse 50 und dem Rastermodul 13. Neben Beleuchtungswinkel-Variationseinheiten mit sich in Richtung auf die optische Achse 2 zu verjüngenden Keilformen, wie vorstehend im Zusammenhang mit den Fig. 28, 30 beschrieben, können weitere Beleuchtungswinkel-Variationseinheiten 76, 77 zwischen der Pupillenlinse 50 und dem Rastermodul 13 angeordnet sein, deren Keilformen im x-z-Schnitt nach außen hin spitz zulaufen. Diese verschiedenen Beleuchtungswinkel-Variationseinheiten 64, 65 oder 73, 74 einerseits und 76, 77 andererseits können in verschiedenen, zueinander beabstandeten Anordnungsebenen 78, 79 zwischen der Pupillenlinse 50 und dem Rastermodul 13 angeordnet sein.

Auch die zuletzt beschriebenen Varianten der Beleuchtungswinkel-Variationseinrichtung 44a, 51 und 63 können mit einer Messeinrichtung 32 und einer Steuer-/Regeleinheit 33 zusammenarbeiten, wie vorstehend im Zusammenhang mit den Ausführungen nach den Fig. 1 bis 14 erläutert. Die Steuer-/Regeleinheit 33 steht dann mit den Verlagerungsantrieben 49, 52 bzw. 72 in Signalverbindung.

Die Beleuchtungswinkel-Variationseinrichtungen 63 und 63a können, wie in den Fig. 32 bis 34 gezeigt, kombiniert werden. Hierzu werden zwei Paare 83, 84 von Beleuchtungswinkel-Variationseinheiten 77, 64 einerseits und 65, 76 andererseits als integrierte Beleuchtungswinkel-Variationsmodule miteinander verbunden.

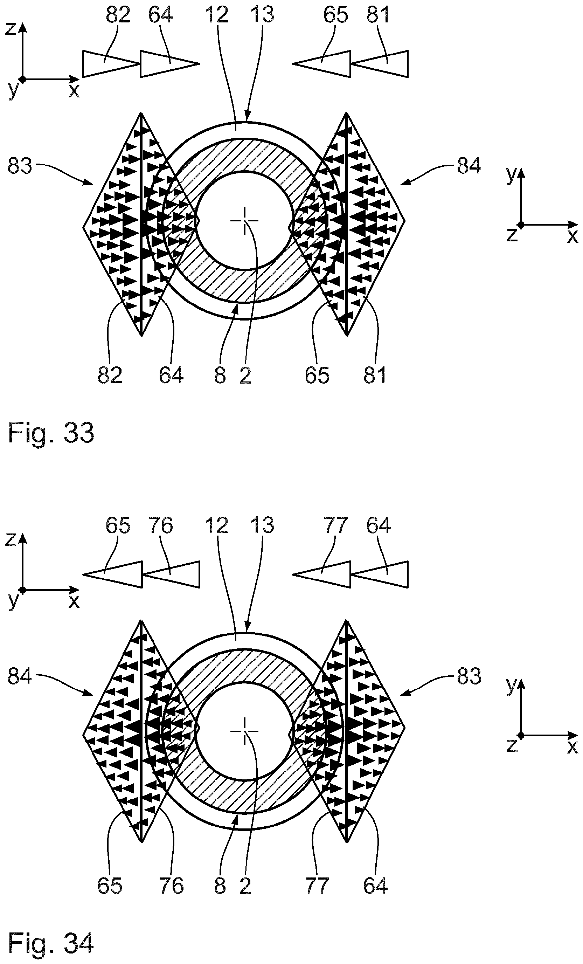

Die Darstellung der Fig. 33 und 34 ist analog zur derjenigen nach den Fig. 28 und 29.

Die Paare 83, 84 können in voneinander beabstandeten Verlagerungsebenen 85, 86, die parallel zur xy-Ebene verlaufen, zwischen der Pupillenlinse 50 und dem Rastermodul 13 über Verlagerungsantriebe 87 unabhängig voneinander verlagert.

Fig. 33 zeigt die Relativposition der Paare 83, 84, bei der Beleuchtungswinkel-Variationseinheiten 64, 65 wirksam sind. Diese Relativposition entspricht der Wirkstellung nach Fig. 28.

Fig. 34 zeigt die Relativposition, bei der die jeweils anderen Beleuchtungswinkel-Variationseinheiten 76, 77 der Paare 83, 84 für die Beleuchtungsstrahlung 8 wirksam werden, die Beleuchtungsstrahlung 8 also abschnittsweise in der xz-Ablenkebene ablenken.

In Bezug auf die in der Fig. 34 dargestellten xy-Projektion haben die Paare 83. 84 also im Vergleich zur Relativposition nach Fig. 33 ihre Plätze getauscht.

Die vier Beleuchtungswinkel-Variationseinheiten 64, 65, 76, 77 können über die paarweise Anordnung nach den Fig. 32 bis 34 also mit genau zwei Verlagerungsaktoren 87 betrieben werden.

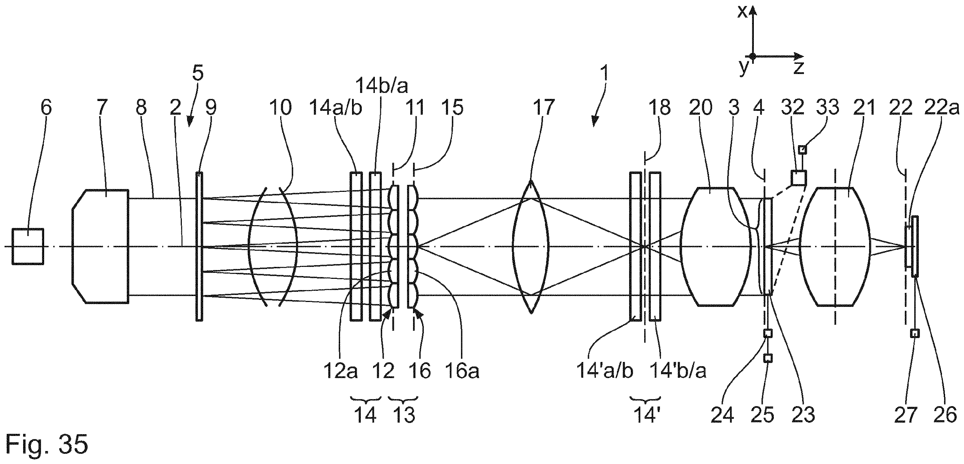

Fig. 35 zeigt eine weitere Anordnungsvariante für eine Beleuchtungswinkel-Variationseinrichtung. Neben der Anordnung der Beleuchtungswinkel-Variationseinrichtung 14 vor dem Rastermodul 13, wie vorstehend im Zusammenhang zum Beispiel mit der Fig. 1 bereits erläutert, ist in der Fig. 35 auch eine Anordnung einer Beleuchtungswinkel-Variationseinrichtung am Beispiel einer Beleuchtungswinkel-Variationseinrichtung 14' in der Feld-Zwischenebene 18 gezeigt. Die Beleuchtungswinkel-Variationseinrichtung 14' mit wiederum zwei Beleuchtungswinkel-Variationseinheiten 14'a, 14'b kann alternativ oder in Kombination zur vorstehend erläuterten Beleuchtungswinkel-Variationseinrichtung 14 eingesetzt werden.

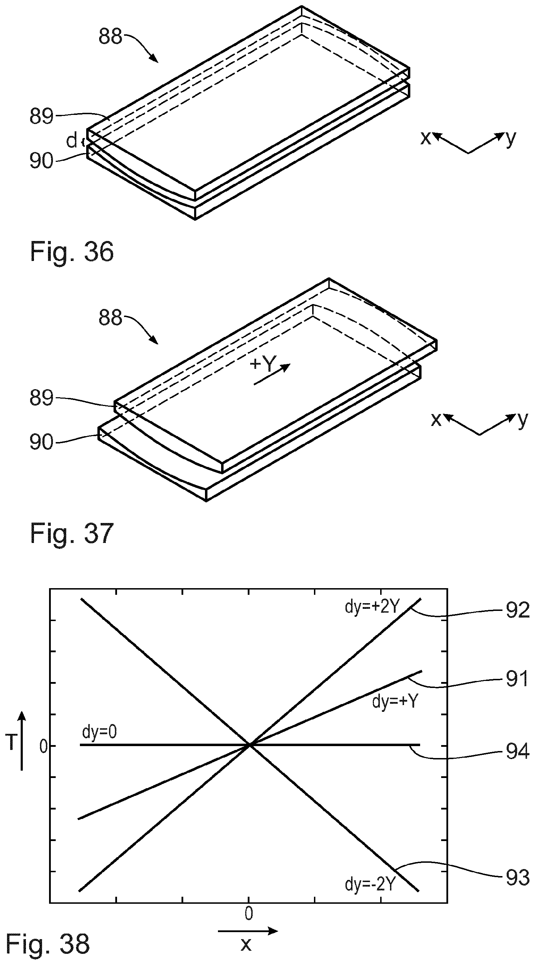

Grundsätzlich kann für beide Beleuchtungswinkel-Variationseinrichtungen 14, 14' eine der nachfolgend im Zusammenhang mit den Figuren 36 bis 55 noch beschriebenen Beleuchtungswinkel-Variationseinrichtungen zum Einsatz kommen.

Die Anordnung der Beleuchtungswinkel-Variationseinrichtung vor dem Rastermodul 13 kann Telezentriewert-Änderungen über Intensitätsvariationen herbeiführen, die durch das Zusammenspiel der Beleuchtungswinkel-Variationseinrichtung einerseits und des nachfolgenden Rastermoduls 13 andererseits herbeigeführt werden, wie dies vorstehend insbesondere im Zusammenhang mit den Figuren 12 bis 14 erläutert ist. Eine Anordnung der Beleuchtungswinkel-Variationseinrichtung in einer Feldebene der Beleuchtungsoptik, also beispielsweise in der Feld-Zwischenebene 18, führt über die Wirkung der Beleuchtungswinkel-Variationseinrichtung eine vom Ort auf dem Beleuchtungsfeld 3 abhängige Richtungsänderung eines gesamten, diesen Feldpunkt beaufschlagenden Lichtbündels des Beleuchtungslichts 8 herbei. Dies wird auch als geometrische Telezentrieänderung bezeichnet. Beim Beleuchtungssystem 5 können Beleuchtungswinkel-Variationseinrichtungen sowohl vor dem Rastermodul 13 als auch in der Feld-Zwischenebene 18 vorgesehen sein. Alternativ ist auch eine Anordnung möglich, bei der ausschließlich vor dem Rastermodul 13 oder ausschließlich in einer Feldebene der Beleuchtungsoptik, beispielsweise in der Feld-Zwischenebene 18, eine Beleuchtungswinkel-Variationseinrichtung angeordnet ist.

Anhand der Fig. 36 bis 38 wird nachfolgend eine weitere Ausführung einer Beleuchtungswinkel-Variationseinrichtung 88 beschrieben. Komponenten und Funktionen, die denjenigen entsprechen, die vorstehend unter Bezugnahme auf die Fig. 1 bis 35 bereits erläutert wurden, tragen die gleichen Bezugsziffern und werden nicht nochmals im Einzelnen diskutiert.

Die Beleuchtungswinkel-Variationseinrichtung 88 hat zwei refraktive optische Platten 89, 90. Beide Platten haben die gleiche Raumform und weisen jeweils eine plane optische Fläche und eine gekrümmte optische Fläche auf. Ein Höhenprofil H(x, y) der Platten 89, 90 hat folgende funktionale Form:

$$H(x, y) = A + Bx^2 y$$

Die y-Koordinate verläuft dabei parallel zur Objektverlagerungsrichtung. Die x-Koordinate verläuft senkrecht zur y-Koordinate und parallel zur Feldhöhe des Beleuchtungsfeldes 3. Sowohl die x- als auch die y-Koordinate verlaufen senkrecht zur optischen Achse 2, also senkrecht zum Strahlengang des Beleuchtungslichts 8.

A und B sind in der vorstehenden Formel frei wählbare Parameter, über die ein gewünschter Verlauf der funktionalen Abhängigkeit des Höhenprofils von den Koordinaten x und y eingestellt werden kann. Insgesamt ergibt sich also jeweils ein parabolisches xz-Profil der gekrümmten Oberflächen der beiden Platten 89, 90, wobei sich die Parabelform abhängig von der y-Position dieses xz-Schnitts ändert.

Fig. 36 zeigt die Beleuchtungswinkel-Variationseinrichtung 88 in einer Nullstellung, bei der die beiden Platten mit einander zugewandten gekrümmten Oberflächen so zueinander orientiert sind, dass ein Luftspalt d unabhängig vom Plattenort jeweils die gleiche Luftspaltweite bzw. den gleichen Luftabstand hat. In der Nullstellung haben die beiden Platten 89, 90 also unabhängig vom betrachteten Ort x, y den gleichen Luftabstand zueinander. In der Neutralstellung nach Fig. 36 hat die Beleuchtungswinkel-Variationseinrichtung keine winkelbeeinflussende Wirkung auf das Beleuchtungslicht 8.

Fig. 37 zeigt die Beleuchtungswinkel-Variationseinrichtung 88 in einer Wirkstellung, in der die in der Fig. 37 obere Platte 89 relativ zur unteren Platte 90 um einen Verlagerungswert "+Y" in der x-Richtung, also parallel zu der Objektverlagerungsrichtung des Objekts im Beleuchtungsfeld 3, verlagert ist. Aufgrund der y-Abhängigkeit des Parabel-Höhenprofils der einander zugewandten gekrümmten Oberflächen der Platten 89, 90 ergibt sich nun eine Luftspaltvariation über die x-Koordinate zwischen den Platten 89, 90, die ihrerseits parabolisch von x abhängt. Aufgrund der linearen Abhängigkeit der Höhenprofile von der y-Koordinate ist diese parabolische x-Variation des Luftspalts von der y-Koordinate im Wesentlichen unabhängig.

Aufgrund der parabolischen x-Variation des Luftspaltes zwischen den Platten 89, 90 in der Wirkstellung nach Fig. 37 ergibt sich ein linearer Telezentriewertverlauf 91, der in der Fig. 38 dargestellt ist. Der Telezentriewertverlauf 91 hat eine positive Steigung, die mit dem Verschiebeweg "+Y" korreliert.

Zusätzlich eingetragen sind in der Fig. 38 weitere Telezentriewertverläufe 92, 93 und 94 für die Relativverschiebungen "+2Y", "-2Y" und "0" zwischen den Platten 89 und 90. Die Relativverschiebung "0" entspricht der Neutralstellung nach Fig. 36.

Analog zu dem, was vorstehend im Zusammenhang besonders mit der Fig. 14 bereits erläutert wurde, lässt sich auch mit der Beleuchtungswinkel-Variationseinrichtung 88 ein linearer Telezentriewertverlauf stufenlos beeinflussen. Ein derartiger Telezentrieverlauf lässt sich bei dieser Ausführungsform allgemein als

$$T(x; Y) = d/dx \, (H \, (x, y) + H \, (x, y - Y))$$

darstellen.

H (x, y) ist dabei das Höhenprofil der Platten 89 und 90.

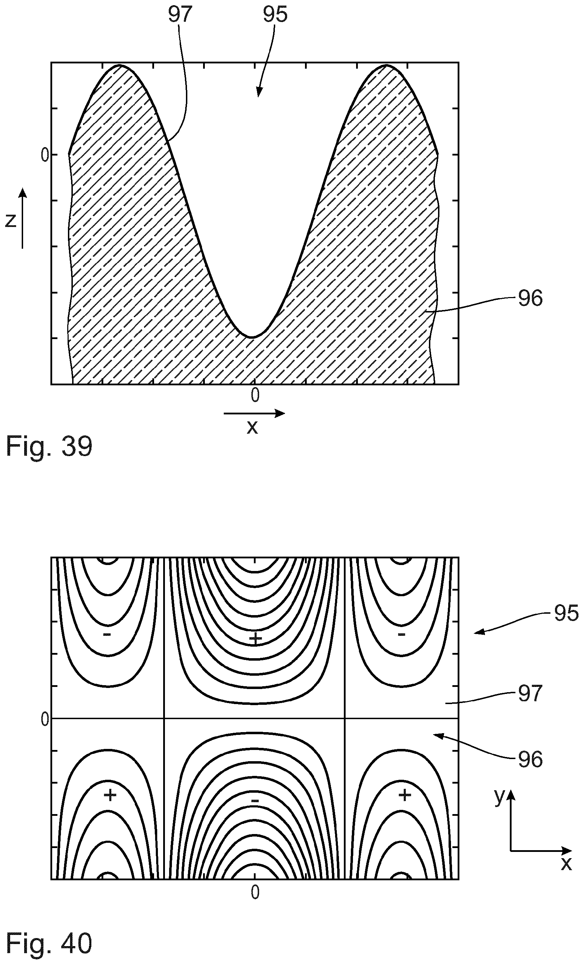

Anhand der Fig. 39 und 40 wird nachfolgend eine weitere, zu den Fig. 37 und 38 ähnliche Ausführung einer Beleuchtungswinkel-Variationseinrichtung 95 erläutert. Komponenten und Funktionen, die denjenigen entsprechen, die vorstehend anhand der Fig. 1 bis 38 und insbesondere anhand der Fig. 36 und 37 bereits erläutert wurden, tragen die gleichen Bezugsziffern und werden nicht nochmals im Einzelnen diskutiert.

Dargestellt ist von der Beleuchtungswinkel-Variationseinrichtung 95 in der Fig. 39 im xz-Schnitt eine von zwei refraktiven optischen Platten 96. Die optischen Platten 96 haben wiederum eine plane Fläche und eine gegenüberliegende gekrümmte Oberfläche 97. Eine Krümmung der gekrümmten Oberfläche 97 folgt bei der Ausführung nach den Fig. 39 und 40 abhängig von der x-Koordinate parallel zur Feldhöhe einer Kosinusfunktion.

Fig. 40 zeigt ein Höhenprofil einer der beiden Platten 96 in einer Aufsicht auf die gekrümmte Oberfläche 97. Ähnlich wie bei den gekrümmten Flächen der optischen Platten 89, 90 der Ausführung nach den Fig. 36 und 37 ist dem Kosinus-Verlauf über die x-Koordinate ein linearer Verlauf des Höhenprofils über die y-Koordinate überlagert. Bei negativen y-Werten entspricht der Kosinus-Verlauf des Höhenprofils über die x-Koordinate qualitativ dem Verlauf nach Fig. 39. Bei positiven y-Werten ist der Kosinus-Verlauf genau gespiegelt mit einem Maximum im Bereich von x=0 und zwei Minima bei negativen und positiven x-Werten. Bei y=0 ist die Höhe der gekrümmten Oberfläche 97 unabhängig von der x-Koordinate konstant. Hier liegt also ein Sattelbereich der gekrümmten Oberfläche 97 vor.

Bei der Beleuchtungswinkel-Variationseinrichtung 95 sind wiederum zwei hinsichtlich ihrer Höhenprofilierung identisch ausgeführte refraktive optische Platten 96 mit ihren gekrümmten optischen Oberflächen so zueinander orientiert, dass in einer Neutralstellung analog zur Stellung nach Fig. 36 ein Luftspalt zwischen den beiden Platten 96 eine konstante z-Erstreckung unabhängig von der x- bzw. y-Koordinate hat.

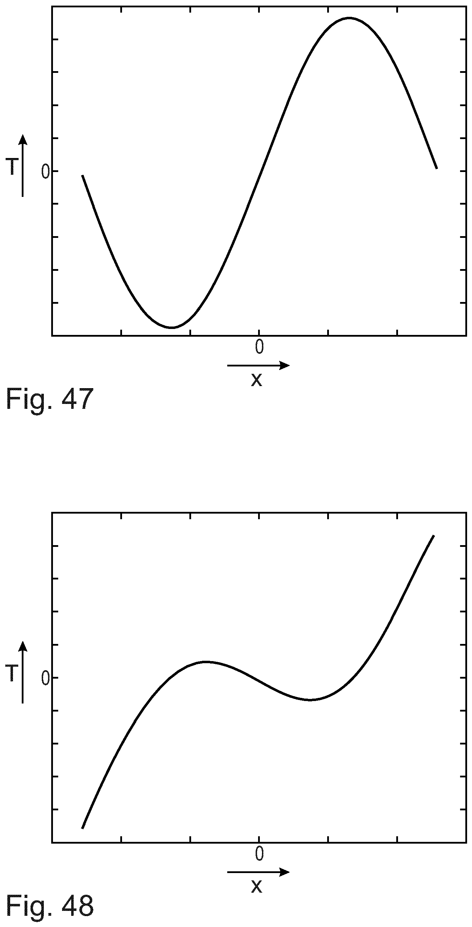

Über die Größe einer y-Verschiebung, also einer Verschiebung parallel zur Objektverlagerungsrichtung, kann wiederum eine Größe einer kosinusförmigen Luftspalt-Variation über die x-Koordinate eingestellt werden. Dies führt zu einem über die Feldhöhe x sinusförmigen Telezentrieverlauf (vgl. Fig. 47). Die Größe der Extremwerte dieses Sinusverlaufs lässt sich über den Absolutwert "Y" der Verschiebung der beiden Platten 96 zueinander stufenlos einstellen, wie vorstehend im Zusammenhang mit der Fig. 38 bei der Beleuchtungswinkel-Variationseinrichtung 88 bereits erläutert.

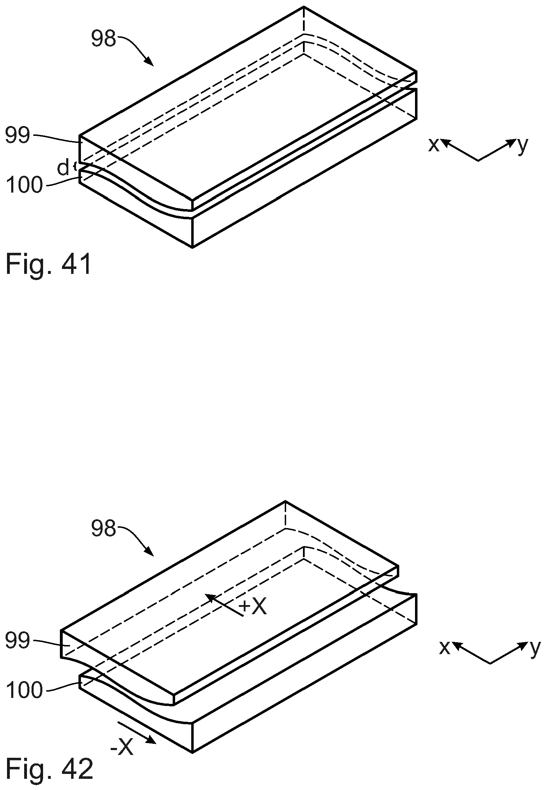

Anhand der Fig. 41 bis 44 wird nachfolgend eine weitere Ausführung einer Beleuchtungswinkel-Variationseinrichtung 98 erläutert. Komponenten und Funktionen, die denjenigen entsprechen, die vorstehend unter Bezugnahme auf die Fig. 1 bis 40 bereits beschrieben wurden, tragen die gleichen Bezugsziffern und werden nicht nochmals im Einzelnen diskutiert.

Die Beleuchtungswinkel-Variationseinrichtung 98 hat vergleichbar zu den Beleuchtungswinkel-Variationseinrichtungen 88 und 95 zwei refraktive optische Platten 99, 100, die jeweils eine plane und eine gekrümmte optische Oberfläche aufweisen, wobei die beiden Platten 99, 100 so angeordnet sind, dass ihre gekrümmten Oberflächen einander zugewandt sind. Diese gekrümmten Oberflächen haben ein Höhenprofil in der Ablenkebene xz, also senkrecht zur Objektverlagerungsrichtung y, welches einem Polynom dritter Ordnung folgt.

Fig. 41 zeigt die Beleuchtungswinkel-Variationseinrichtung 98 mit den Platten 99, 100 in der Neutralstellung, also mit konstantem Luftspalt d.

Fig. 42 zeigt die Platte 99 um einen Verschiebeweg "+X" und die untere Platte 100 um einen Verschiebeweg "-X" in der x-Richtung, also in einer Richtung senkrecht zur Objektverlagerungsrichtung y und zudem senkrecht zum Strahlengang des Beleuchtungslichts 8 durch die Beleuchtungswinkel-Variationseinrichtung 98, verlagert. Die Verschiebewege +X und -X beziehen sich auf eine Verlagerung relativ zu stationären Komponenten der Beleuchtungsoptik, die einen Verlauf der optischen Achse 2 vorgeben. Ein Beispiel für eine solche Komponente, relativ zu der sich die Verschiebewege +X und -X ergeben, ist das Rastermodul 13.

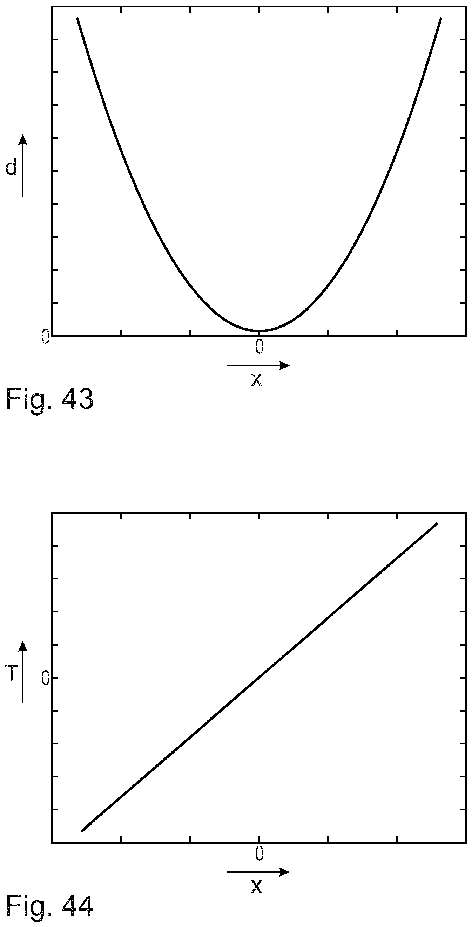

Fig. 43 zeigt in der Relativstellung der Platten 99, 100 nach Fig. 42 die Abhängigkeit einer z-Erstreckung des Luftspaltes d von der Feldhöhe, also von der x-Dimension. Da das Höhenprofil der Platten 99, 100 unabhängig von der y-Dimension ist, ergibt sich für jede y-Koordinate das gleiche Differenzprofil wie in der Fig. 43 dargestellt. Entsprechend dem als Polynom dritter Ordnung ausgeführten Höhenprofil der gekrümmten Oberflächen der Platten 99, 100 ergibt sich eine parabolische Luftspalt-Variation. Diese Luftspalt-Variation hat ein globales Minimum bei der Feldhöhe x=0. Entsprechend diesem Differenz- bzw. Luftspaltprofil ergibt sich eine Telezentriewertabhängigkeit von der Feldhöhe x, die in der Fig. 44 dargestellt ist. Es ergibt sich wiederum ein linearer Verlauf der Telezentrie über die Feldhöhe. Abhängig von der Größe des Verschiebewegs "X" und abhängig von der Wahl der Polynomfunktion für das Höhenprofil der gekrümmten Oberflächen der Platten 99, 100 ergibt sich die Steigung der linearen Abhängigkeit der Telezentriewertvariation über die Feldhöhe. Auch mit der Beleuchtungswinkel-Variationseinrichtung 98 lässt sich über die Größe des Verschiebewegs "X" die Steigung der Telezentriewertvariation stufenlos anpassen.

Allgemein gilt hier für die Variation des Telezentriewertes T:

$$T\,(x;\,X) = d/dx\,(H\,(x{+}X1) + H\,(x - X2))$$

H (x) ist hierbei die funktionale Darstellung des Höhenprofils der Platten 99 und 100. X1 steht beispielhaft für eine positive Verschiebung in Richtung der x-Achse und X2 steht beispielhaft für eine Verschiebung entgegen der x-Richtung. Absolut können die Verschiebewege X1 und X2 verschiedene Beträge haben, können alternativ aber auch den gleichen Betrag haben.

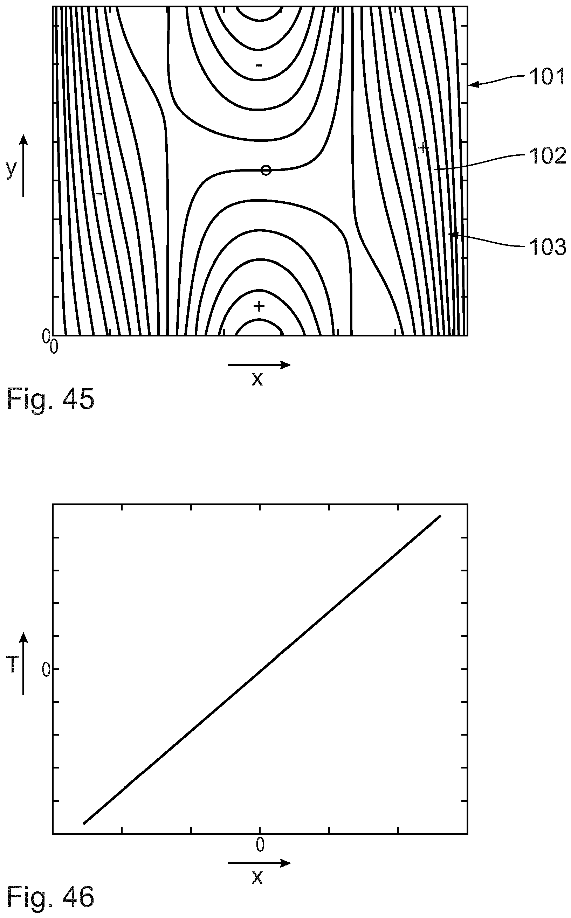

Anhand der Fig. 45 bis 48 wird nachfolgend eine weitere Ausführung einer Beleuchtungswinkel-Variationseinrichtung 101 beschrieben. Komponenten und Funktionen, die denjenigen entsprechen, die vorstehend unter Bezugnahme auf die Fig. 1 bis 44 und insbesondere unter Bezugnahme auf die Fig. 36 bis 44 bereits erläutert wurden, tragen die gleichen Bezugsziffern und werden nicht nochmals im Einzelnen diskutiert.

Fig. 45 zeigt in einer zu Fig. 40 ähnlichen Darstellung ein Höhenprofil einer gekrümmten Oberfläche 102 einer refraktiven optischen Platte 103 der Beleuchtungswinkel-Variationseinrichtung 101. Das Höhenprofil nach Fig. 45 ergibt sich als Addition des Höhenprofils der optischen Platte 96 nach Fig. 40 mit dem Höhenprofil der optischen Platte 100 nach Fig. 41. Auch bei der Beleuchtungswinkel-Variationseinrichtung 101 liegen zwei refraktive optische Platten mit identischen Höhenprofilen gemäß Fig. 45 vor, die so mit den einander zugewandten gekrümmten Oberflächen angeordnet sind, dass sich in einer Neutralstellung ein konstanter Luftspalt über die gesamte Ausdehnung der beiden Platten zueinander ergibt. Es resultiert die Beleuchtungswinkel-Variationseinrichtung 101, bei der sowohl über eine Verlagerung der beiden optischen Platten 103 in der y-Richtung (vgl. die Erläuterungen zur Beleuchtungswinkel-Variationseinrichtung 95) als auch in der x-Richtung (vgl. die Erläuterungen zur Beleuchtungswinkel-Variationseinrichtung 98) stufenlose Telezentriewert-Variationseinstellungen vorgenommen werden können.

Bei einer reinen entgegengesetzten Verlagerung der beiden Platten in der x-Richtung, ausgehend von der Neutralstellung, also bei |X1| = |X2|, ergibt sich ein Telezentriewertverlauf nach Fig. 46. Bei einer reinen Verlagerung in der y-Richtung, ausgehend von der Neutralstellung, ergibt sich ein Telezentriewertverlauf gemäß Fig. 47. Bei einer Verlagerung sowohl in der x-Richtung als auch in der y-Richtung, ausgehend von der Neutralstellung, ergibt sich ein Telezentriewertverlauf nach Fig. 48, der als Superposition der beiden Telezentriewertverläufe nach den Fig. 46 und 47 verstanden werden kann.

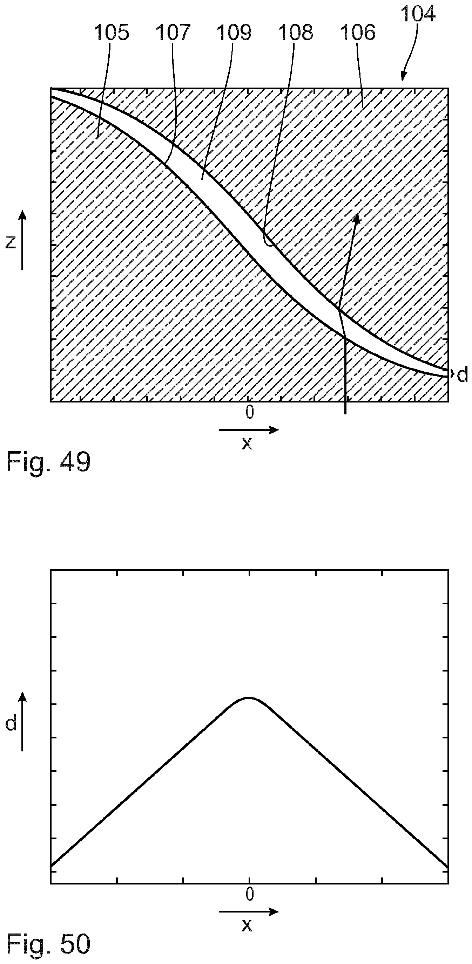

Anhand der Fig. 49 bis 51 wird nachfolgend eine weitere, zu Fig. 45 ähnliche Ausführung einer Beleuchtungswinkel-Variationseinrichtung 104 erläutert. Komponenten und Funktionen, die denjenigen entsprechen, die vorstehend unter Bezugnahme auf die Fig. 1 bis 48 und insbesondere unter Bezugnahme auf die Fig. 36 bis 48 bereits beschrieben wurden, tragen die gleichen Bezugsziffern und werden nicht nochmals im Einzelnen diskutiert.

Die Beleuchtungswinkel-Variationseinrichtung 104 hat zwei refraktive optische Platten 105, 106, deren Höhenprofil in der Fig. 49 in einem xz-Schnitt dargestellt sind. Die beiden Platten 105, 106 weisen wiederum äußere plane optische Flächen und einander zugewandte gekrümmte optische Flächen 107, 108 auf. Zwischen diesen gekrümmten optischen Flächen 107, 108 liegt ein Luftspalt 109 vor. Bei der dargestellten Relativ-Verschiebungsposition "X" der beiden Platten 105, 106 zueinander hat der Luftspalt 109 eine z-Erstreckung, die bei x=0, also in einem Zentrum eines Bündels des Beleuchtungslichts 8, maximal ist und nach beiden Seiten hin zum Rand des Bündels 8, also in Richtung positiver x-Werte und in Richtung negativer x-Werte in der Fig. 49, linear abfällt. Diese, insgesamt V-förmige Abhängigkeit der Luftspaltdicke d von der Feldhöhe ist in der Fig. 50 nochmals dargestellt.

Fig. 51 zeigt eine aus dieser Anordnung der optischen Platten 105, 106 folgende Variation des Telezentriewertes T über die Feldhöhe x. Der Telezentriewert T hat eine Stufenfunktion und ändert seinen Wert bei der Feldhöhe x=0 von einem Wert $-T_0$ hin zu einem Wert $+T_0$. Für Feldhöhenwerte mit einem Absolutwert oberhalb eines gewissen Grenzwertes ist der Telezentriewert konstant bei diesen Werten $+/-T_0$.

Anhand der Fig. 52 bis 55 wird nachfolgend eine weitere Ausführung einer Beleuchtungswinkel-Variationseinrichtung 110 erläutert. Komponenten und Funktionen, die denjenigen entsprechen, die vorstehend unter Bezugnahme auf die Fig. 1 bis 51 und besonders unter Bezugnahme auf die Fig. 36 bis 51 bereits beschrieben wurden, tragen die gleichen Bezugsziffern und werden nicht nochmals im Einzelnen diskutiert.

Fig. 52 zeigt in einem Höhenprofil ähnlich zu dem nach Fig. 45 eine gekrümmte Oberfläche 111 einer optischen Platte 112 der Beleuchtungswinkel-Variationseinrichtung 110. Eine x-Abhängigkeit des Höhenprofils der gekrümmten Oberfläche 110 entspricht in erster Näherung derjenigen nach Fig. 49. Zusätzlich ist die gekrümmte Oberfläche 111 mit einem Keil in x-Richtung überlagert, dessen Stärke sich abhängig von der y-Koordinate linear verändert.

Fig. 53 zeigt in einem xz-Schnitt den Luftspalt zwischen den Platten für eine in y verschobene Relativstellung der Platten 111, 112 zueinander. Dort sind die beiden wiederum identisch hinsichtlich ihrer Höhenprofilierung ausgeführten optischen Platten 111, 112 mit den gekrümmten Oberflächen mit den Höhenprofilen nach der Fig. 52 einander zugewandt so angeordnet, dass sich abhängig von der y-Verschiebung zusätzlich ein sich keilförmig vergrößernder Luftspalt d ergibt.

Fig. 54 zeigt die Luftspaltvariation in der x-Richtung durch die überlagerte Wirkung aufgrund des zusätzlichen y-verschiebungs-abhängigen Keilbeitrages der Luftspaltvariation in der x-Richtung. Die ursprünglich symmetrische V-Funktion ist nun insgesamt aufgrund des zusätzlichen Keilbeitrages verkippt. Bei Werten x<0 hat der Absolutwert der Steigung der Luftspalt-variation einen größeren Wert als für Werte x>0.

Fig. 55 zeigt die Auswirkung der Luftspaltvariation nach Fig. 54 auf die Telezentriewertvariation, abhängig von der Feldhöhe x. Es ergibt sich ein Telezentrieverlauf mit einem Offset, bei dem für Werte x<0 ein größerer absoluter Telezentriewert resultiert als für Werte x>0, wobei wiederum, ähnlich wie beim Telezentriewertverlauf nach Fig. 51, im Bereich von x=0 ein Stufensprung des Telezentriewertes erfolgt.

Zur Vereinfachung der Beschreibung der Wirkungsweise wurden die in den Figuren Fig. 36 bis 55 dargestellten Beleuchtungswinkel-Variationseinheiten stets als Platten mit jeweils einer planen und einer gekrümmtem Fläche beschrieben, wobei die für die Funktion wirksamen gekrümmtem Flächen einander zugewandt sind. Wenn für den Aufbau und die Funktion des optischen Systems vorteilhaft können natürlich die wirksamen gekrümmtem Flächen auch einander abgewandt angeordnet werden. Auch ist es möglich die planen Flächen durch gekrümmte Flächen, insb. sphärische Flächen, zu ersetzen, insbesondere, wenn die entsprechende Beleuchtungswinkelvariationseinheit keine Verschiebung quer zur optischen Achse erfährt.

Fig. 56 zeigt perspektivisch eine weitere Ausführung einer Beleuchtungswinkel-Variationseinrichtung 113. Diese hat eine Grundplatte 114 aus für das Beleuchtungslicht 8 refraktivem Material. Die Grundplatte 114 hat zwei konkavzylindrische Oberflächenabschnitte, zwischen denen ein planparalleler Mittelsteg 115 angeordnet ist. Komplementär zu den beiden zylindrisch konkaven Bereichen rechts und links des Mittelsteges 115 sind zwei plankonvexe Zylinderlinsen 116, 117 angeordnet. Die konvexen Oberflächen der Zylinderlinsen 116, 117 sind den konkaven Oberflächen der Grundplatte 114 zugewandt und haben die gleiche absolute Krümmung. Die Zylinderlinsen 116, 117 sind relativ zur Grundplatte 114 um Achsen parallel zu ihren Zylinderachsen verschwenkbar, so dass ein Winkel einer äußeren planen Oberfläche 118, 119 der Zylinderlinsen 116, 117 zur optischen Austrittsfläche 120 der Grundplatte 114 unabhängig voneinander einstellbar ist. Entsprechend lässt sich ein Wellenfronttipp für die Anteile des Bündels des Beleuchtungslichts 8, welches rechts und links des Mittelstegs 115 auf die Beleuchtungswinkel-Variationseinrichtung 113 trifft, vorgeben.

Die jeweils verlagerbare optische Platte stellt bei den Beleuchtungswinkel-Variationseinrichtungen nach den Fig. 36 bis 55 eine insgesamt verlagerbare Beleuchtungswinkel-Variationseinheit dar.

Die vorstehend im Zusammenhang mit den Fig. 36 ff. erläuterten Beleuchtungswinkel-Variationseinrichtungen stellen Beispiele mit Beleuchtungswinkel-Variationseinheiten dar, die als Asphärenflächen-Komponenten bzw. als Freiformflächen-Komponenten ausgeführt sind.

Bei der Projektionsbelichtung werden das Retikel 23 und der Wafer 22a, der eine für das Beleuchtungslicht 8 lichtempfindliche Beschichtung trägt, bereitgestellt. Anschließend wird zumindest ein Abschnitt des Retikels 23 auf den Wafer 22a mithilfe der Projektionsbelichtungsanlage 1 projiziert. Schließlich wird die mit dem Beleuchtungslicht 8 belichtete lichtempfindliche Schicht auf dem Wafer 22a entwickelt. Auf diese Weise wird das mikro- bzw. nanostrukturierte Bauteil, beispielsweise ein Halbleiterchip, hergestellt.

**Patentansprüche**

1.  Beleuchtungsoptik für die Projektionslithografie zur Beleuchtung eines Beleuchtungsfeldes (3) mit Beleuchtungslicht (8) einer primären Lichtquelle (6)

    - mit mindestens einer Rasteranordnung (12, 16) mit in Rasterzeilen und Rasterspalten angeordneten Rasterelementen (12a, 16a), die das Beleuchtungslicht (8) zur Vorgabe einer Form des Beleuchtungsfeldes (3) beeinflussen,
    - mit einer Übertragungsoptik (17) zur überlagernden Übertragung des Beleuchtungslichts (8) von den Rasterlementen (12a, 16a) hin zum Beleuchtungsfeld (3), in dem ein in einer Objektverlagerungsrichtung (y) verlagerbares Objekt (23) anordenbar ist,
    - mit einer Beleuchtungswinkel-Variationseinrichtung (14. 14'; 34; 44a; 51; 63; 63a; 88; 95; 98; 101; 104; 110; 113), die das Beleuchtungslicht (8), das auf die Beleuchtungswinkel-Variationseinrichtung (14; 34; 44a; 51; 63; 63a; 88; 95; 98; 101; 104; 110; 113) trifft, in einer Ablenkebene (xz) senkrecht zur Objektverlagerungsrichtung (y) ortsabhängig mit unterschiedlichen Ablenkwinkeln ablenkt,
    - wobei die Beleuchtungswinkel-Variationseinrichtung (14, 14'; 34; 44a; 51; 63; 63a; 88; 95; 98; 101; 104; 110; 113) mindestens aufweist:

        -- eine relativ zur Rasteranordnung (12, 16) insgesamt verlagerbare Beleuchtungswinkel-Variationseinheit (14b, 14b'; 34b; 45, 46; 51; 64, 65; 73, 74; 76, 77; 89; 96; 99; 106; 112; 116; 117) zur Erzeugung eines Ablenkwinkels für das Beleuchtungslicht (8) in der Ablenkebene (xz) senkrecht zur Objektverlagerungsrichtung (y),
        - wobei die Verlagerbarkeit der insgesamt verlagerbaren Beleuchtungswinkel-Variationseinheit (14b, 14b'; 34b; 45, 46; 51; 64, 65; 73, 74; 76, 77; 89; 96; 99; 106; 112; 116; 117) relativ zur Rasteranordnung (12, 16) zur Beeinflussung einer Größe des Ablenkwinkels in der Ablenkebene (xz) senkrecht zur Objektverlagerungsrichtung (y) dient.

2.  Beleuchtungsoptik nach Anspruch 1, **dadurch gekennzeichnet, dass** die Beleuchtungswinkel-Variationseinrichtung (14;34) weiterhin aufweist:

    - mindestens eine weitere Beleuchtungswinkel-Variationseinheit (14a, 14a'; 34a; 46, 45; 64, 65; 73, 74; 90; 96; 100; 105; 111; 114) zur Erzeugung mindestens eines weiteren Ablenkwinkels für das Beleuchtungslicht (8) in der Ablenkebene (xz) senkrecht zur Objektverlagerungsrichtung (y),
    - wobei die Beleuchtungswinkel-Variationseinheiten (14a, 14a', 14b; 34a, 34b; 45, 46; 76, 77; 64, 65; 76, 77; 73, 74; 89; 90; 96; 99; 100; 105; 106; 112; 116; 117; 114) so angeordnet sind, dass sie das Beleuchtungslicht (8) nacheinander beeinflussen.

3.  Beleuchtungsoptik nach Anspruch 2, **dadurch gekennzeichnet, dass** die weitere Beleuchtungswinkel-Variationseinheit (14a; 34a) als statische Einheit ausgeführt ist.

4.  Beleuchtungsoptik nach einem der Ansprüche 1 bis 3, **dadurch gekennzeichnet, dass** die weitere Beleuchtungswinkel-Variationseinheit (14a; 34a) absolut unterschiedliche, statische Ablenkwinkel in mindestens zwei Winkelvariationsabschnitten erzeugt.

5.  Beleuchtungsoptik nach einem der Ansprüche 2 bis 4, **dadurch gekennzeichnet, dass** eine maximale Ablenkwirkung der verlagerbaren Beleuchtungswinkel-Variationseinheit (14b; 34b) kleiner ist als eine maximale Ablenkwirkung der weiteren Beleuchtungswinkel-Variationseinheit (14a; 34a).

6.  Beleuchtungsoptik nach einem der Ansprüche 1 bis 5, **dadurch gekennzeichnet, dass** mindestens eine der Beleuchtungswinkel-Variationseinheiten als eine der nachfolgend aufgeführten Komponenten ausgeführt ist:

- Dachkantenprisma (14a, 14b);
- Zylinderlinse (34a, 34b);
- Sattelflächen-Komponente (51);
- Asphärenflächen-Komponente;
- Freiformflächen-Komponente;
- Keilkörper (64, 65; 73, 74; 76, 77);
- Linse (45, 46).

**7.** Beleuchtungsoptik nach Anspruch 6, wobei mindestens eine der Beleuchtungswinkel-Variationseinheiten als Keilkörper (64, 65; 73, 74; 76, 77) ausgeführt ist, wobei für eine Steigung eines Keil-Kantenbereichs (68; 75) in einer Ebene (xy) senkrecht zur Strahlrichtung (z) des Beleuchtungslichts (8) gilt: $|dy/dx| \geq 2$, wobei y längs der Objektverlagerungsrichtung (y) verläuft.

**8.** Beleuchtungsoptik nach einem der Ansprüche 1 bis 7, **dadurch gekennzeichnet, dass** die verlagerbare Beleuchtungswinkel-Variationseinheit (14b; 34b; 51) um eine optische Achse (2) der Beleuchtungsoptik schwenkbar ausgeführt ist.

**9.** Beleuchtungsoptik nach einem der Ansprüche 1 bis 8, **gekennzeichnet durch** einen Verlagerungsantrieb (30; 49; 52; 72) zur Verlagerung der mindestens einen verlagerbaren Beleuchtungswinkel-Variationseinheit (14b; 34b; 45, 46; 51; 64, 65; 73, 74; 76, 77) zur Rasteranordnung (12, 16).

**10.** Beleuchtungsoptik nach einem der Ansprüche 1 bis 9, **gekennzeichnet durch** eine Messeinrichtung (32) zum Vermessen eines Beleuchtungsparameters des Beleuchtungslichts (8) über das Beleuchtungsfeld (3).

**11.** Beleuchtungsoptik nach Anspruch 9 und 10, **dadurch gekennzeichnet, dass** die Messeinrichtung (32) über eine Steuer-/Regeleinheit (33) mit dem Verlagerungsantrieb (30; 49; 52; 72) in Signalverbindung steht.

**12.** Optisches System mit einer Beleuchtungsoptik nach einem der Ansprüche 1 bis 11 und mit einer Projektionsoptik (21) zur Abbildung zumindest eines Teils des Beleuchtungsfeldes (3) in ein Bildfeld in einer Bildebene (22).

**13.** Projektionsbelichtungsanlage (1)

- mit einem optischen System nach Anspruch 12,
- mit einer primären Lichtquelle (6),
- mit einem Objekthalter (24) mit einem Objektverlagerungsantrieb (25) zur Halterung eines Objekts (23) im Beleuchtungsfeld (3).
- mit einem Waferhalter (26) mit einem Waferverlagerungsantrieb (27) zur Halterung eines Wafers (22a) im Bildfeld.

**14.** Verfahren zur mikrolithografischen Herstellung mikrostrukturierter Bauelemente mit folgenden Schritten:

- Bereitstellen eines Substrats (22a), auf das zumindest teilweise eine Schicht aus einem lichtempfindlichen Material aufgebracht ist,
- Bereitstellen eines Retikels (23), das abzubildende Strukturen aufweist,
- Bereitstellen einer Projektionsbelichtungsanlage (1) nach Anspruch 13,
- Projizieren wenigstens eins Teils des Retikels (23) auf einen Bereich der Schicht mithilfe der Projektionsbelichtungsanlage (1).

**Claims**

**1.** Illumination optical unit for projection lithography for illuminating an illumination field (3) with illumination light (8) of a primary light source (6)

- having at least one raster arrangement (12, 16) having raster elements (12a, 16a) arranged in raster rows and raster columns, said raster elements influencing the illumination light (8) for predefining a shape of the illumination field (3),
- having a transfer optical unit (17) for the superimposing transfer of the illumination light (8) from the raster elements (12a, 16a) towards the illumination field (3), in which an object (23) displaceable in an object displacement direction (y) is arrangeable,

- having an illumination angle variation device (14, 14'; 34; 44a; 51; 63; 63a; 88; 95; 98; 101; 104; 110; 113), which deflects the illumination light (8) incident on the illumination angle variation device (14; 34; 44a; 51; 63; 63a; 88; 95; 98; 101; 104; 110; 113) in a deflection plane (xz) perpendicular to the object displacement direction (y) in a spatially dependent manner with different deflection angles,
- wherein the illumination angle variation device (14, 14'; 34; 44a; 51; 63; 63a; 88; 95; 98; 101; 104; 110; 113) has at least:

-- one illumination angle variation unit (14b, 14b'; 34b; 45, 46; 51; 64, 65; 73, 74; 76, 77; 89; 96; 99; 106; 112; 116; 117), displaceable overall relative to the raster arrangement (12, 16), for generating a deflection angle for the illumination light (8) in the deflection plane (xz) perpendicular to the object displacement direction (y),

- wherein the displaceability of the overall displaceable illumination angle variation unit (14b, 14b'; 34b; 45, 46; 51; 64, 65; 73, 74; 76, 77; 89; 96; 99; 106; 112; 116; 117) relative to the raster arrangement (12, 16) serves for influencing a magnitude of the deflection angle in the deflection plane (xz) perpendicular to the object displacement direction (y).

2. Illumination optical unit according to Claim 1, **characterized in that** the illumination angle variation device (14; 34) furthermore has:

- at least one further illumination angle variation unit (14a, 14a'; 34a; 46, 45; 64, 65; 73, 74; 90; 96; 100; 105; 111; 114) for generating at least one further deflection angle for the illumination light (8) in the deflection plane (xz) perpendicular to the object displacement direction (y),
- wherein the illumination angle variation units (14a, 14a', 14b; 34a, 34b; 45, 46; 76, 77, 64, 65; 76, 77, 73, 74; 89; 90; 96; 99; 100; 105; 106; 112; 116; 117; 114) are arranged in such a way that they successively influence the illumination light (8).

3. Illumination optical unit according to Claim 2, **characterized in that** the further illumination angle variation unit (14a; 34a) is embodied as a static unit.

4. Illumination optical unit according to any one of Claims 1 to 3, **characterized in that** the further illumination angle variation unit (14a; 34a) generates static deflection angles that are different in absolute terms in at least two angle variation portions.

5. Illumination optical unit according to any one of Claims 2 to 4, **characterized in that** a maximum deflection effect of the displaceable illumination angle variation unit (14b; 34b) is smaller than a maximum deflection effect of the further illumination angle variation unit (14a; 34a).

6. Illumination optical unit according to any of Claims 1 to 5, **characterized in that** at least one of the illumination angle variation units is embodied as one of the components presented below:

- roof edge prism (14a, 14b);
- cylindrical lens element (34a, 34b);
- saddle surface component (51);
- asphere surface component;
- freeform surface component;
- wedge body (64, 65; 73, 74; 76, 77);
- lens element (45, 46).

7. Illumination optical unit according to Claim 6, wherein at least one of the illumination angle variation units is embodied as a wedge body (64, 65; 73, 74; 76, 77), wherein $|dy / dx| \geq 2$ for a gradient of a wedge edge region (68; 75) in a plane (xy) perpendicular to the beam direction (z) of the illumination light (8), wherein y runs along the object displacement direction (y).

8. Illumination optical unit according to any one of Claims 1 to 7, **characterized in that** the displaceable illumination angle variation unit (14b; 34b; 51) is embodied to be pivotable about an optical axis (2) of the illumination optical unit.

9. Illumination optical unit according to any one of Claims 1 to 8, **characterized by** a displacement drive (30; 49; 52; 72) for displacing the at least one displaceable illumination angle variation unit (14b; 34b; 45, 46; 51; 64, 65; 73, 74; 76, 77) with respect to the raster arrangement (12, 16).

10. Illumination optical unit according to any one of Claims 1 to 9, **characterized by** a measuring device (32) for measuring an illumination parameter of the illumination light (8) over the illumination field (3) .

11. Illumination optical unit according to Claims 9 and 10, **characterized in that** the measuring device (32) is signal-connected to the displacement drive (30; 49; 52; 72) via a control/regulating unit (33).

12. Optical system having an illumination optical unit according to any one of Claims 1 to 11 and having a projection optical unit (21) for imaging at least a part of the illumination field (3) into an image field in an image plane (22).

13. Projection exposure apparatus (1)

   - having an optical system according to Claim 12,
   - having a primary light source (6),
   - having an object holder (24) with an object displacement drive (25) for mounting an object (23) in the illumination field (3),
   - having a wafer holder (26) with a wafer displacement drive (27) for mounting a wafer (22a) in the image field.

14. Method for microlithographically producing microstructured components having the following steps:

   - providing a substrate (22a), to which a layer composed of a light-sensitive material is at least partly applied,
   - providing a reticle (23), which has structures to be imaged,
   - providing a projection exposure apparatus (1) according to Claim 13,
   - projecting at least a part of the reticle (23) onto a region of the layer with the aid of the projection exposure apparatus (1).

**Revendications**

1. Optique d'éclairage pour lithographie de projection pour l'éclairage d'un champ d'éclairage (3) avec une lumière d'éclairage (8) provenant d'une source de lumière primaire (6), comprenant

   - au moins un agencement de trame (12, 16) comportant des éléments de trame (12a, 16a) agencés en lignes de trame et en colonnes de trame, qui agissent sur la lumière d'éclairage (8) pour prédéfinir une forme du champ d'éclairage (3),
   - une optique de transmission (17) pour la transmission superposée de la lumière d'éclairage (8) depuis les éléments de trame (12a, 16a) vers le champ d'éclairage (3), dans lequel peut être disposé un objet (23) pouvant être déplacé dans une direction de déplacement d'objet (y),
   - un dispositif de variation d'angle d'éclairage (14, 14' ; 34 ; 44a ; 51 ; 63 ; 63a ; 88 ; 95 ; 98 ; 101 ; 104 ; 110 ; 113) qui dévie la lumière d'éclairage (8) incidente sur le dispositif de variation d'angle d'éclairage (14 ; 34 ; 44a ; 51 ; 63 ; 63a ; 88 ; 95 ; 98 ; 101 ; 104 ; 110 ; 113) dans un plan de déviation (xz) perpendiculaire à la direction de déplacement d'objet (y) selon différents angles de déviation en fonction de la position,
   - dans lequel le dispositif de variation d'angle d'éclairage (14, 14' ; 34 ; 44a ; 51 ; 63 ; 63a ; 88 ; 95 ; 98 ; 101 ; 104 ; 110 ; 113) comporte au moins :

      -- une unité de variation d'angle d'éclairage (14b, 14b' ; 34b ; 45, 46 ; 51 ; 64, 65 ; 73, 74 ; 76, 77 ; 89 ; 96 ; 99 ; 106 ; 112 ; 116 ; 117) pouvant être déplacée dans son ensemble par rapport à l'agencement de trame (12, 16) pour générer un angle de déviation pour la lumière d'éclairage (8) dans le plan de déviation (xz) perpendiculaire à la direction de déplacement d'objet (y),

   - dans lequel la capacité de déplacement de l'unité de variation d'angle d'éclairage (14b, 14b' ; 34b ; 45, 46 ; 51 ; 64, 65 ; 73, 74 ; 76, 77 ; 89 ; 96 ; 99 ; 106 ; 112 ; 116 ; 117) pouvant être déplacée dans son ensemble par rapport à l'agencement de trame (12, 16) sert à agir sur une valeur de l'angle de déviation dans le plan de déviation (xz) perpendiculaire à la direction de déplacement d'objet (y).

2. Optique d'éclairage selon la revendication 1, **caractérisée en ce que** le dispositif de variation d'angle d'éclairage (14 ; 34) comporte en outre :

- au moins une autre unité de variation d'angle d'éclairage (14a, 14a' ; 34a ; 46, 45 ; 64, 65 ; 73, 74 ; 90 ; 96 ; 100 ; 105 ; 111 ; 114) destinée à générer au moins un autre angle de déviation pour la lumière d'éclairage (8) dans le plan de déviation (xz) perpendiculaire à la direction de déplacement d'objet (y),
- dans lequel les unités de variation d'angle d'éclairage (14a, 14a', 14b ; 34a, 34b ; 45, 46 ; 76, 77, 64, 65 ; 76, 77, 73, 74 ; 89 ; 90 ; 96 ; 99 ; 100 ; 105 ; 106 ; 112 ; 116 ; 117 ; 114) sont disposées de manière à ce qu'elles agissent successivement sur la lumière d'éclairage (8).

3. Optique d'éclairage selon la revendication 2, **caractérisée en ce que** l'autre unité de variation d'angle d'éclairage (14a ; 34a) est réalisée sous la forme d'une unité statique.

4. Optique d'éclairage selon l'une des revendications 1 à 3, **caractérisée en ce que** l'autre unité de variation d'angle d'éclairage (14a ; 34a) génère des angles de déviation statiques de valeurs absolues différentes dans au moins deux sections de variation d'angle.

5. Optique d'éclairage selon l'une des revendications 2 à 4, **caractérisée en ce qu'**un effet de déviation maximum de l'unité de variation d'angle d'éclairage (14b ; 34b) pouvant être déplacée est inférieur à un effet de déviation maximum de l'autre unité de variation d'angle d'éclairage (14a ; 34a).

6. Optique d'éclairage selon l'une des revendications 1 à 5, **caractérisée en ce qu'**au moins l'une des unités de variation d'angle d'éclairage est réalisée sous la forme de l'un des composants indiqués ci-dessous :

- prisme en arête de toit (14a, 14b) ;
- lentille cylindrique (34a, 34b) ;
- composant à surface de selle (51) ;
- composant à surface asphérique ;
- composant à surface de forme libre ;
- corps cunéiforme (64, 65 ; 73, 74 ; 76, 77) ;
- lentille (45, 46).

7. Optique d'éclairage selon la revendication 6, dans laquelle au moins l'une des unités de variation d'angle d'éclairage est réalisée sous la forme d'un corps cunéiforme (64, 65 ; 73, 74 ; 76, 77), dans laquelle, pour une pente d'une zone de bord cunéiforme (68 ; 75) dans un plan (xy) perpendiculaire à la direction du faisceau (z) de la lumière d'éclairage (8), on a : $|dy / dx| \geq 2$, où y s'étend dans la direction de déplacement d'objet (y).

8. Optique d'éclairage selon l'une des revendications 1 à 7, **caractérisée en ce que** l'unité de variation d'angle d'éclairage (14b ; 34b ; 51) pouvant être déplacée est conçue pour pouvoir pivoter autour d'un axe optique (2) de l'optique d'éclairage.

9. Optique d'éclairage selon l'une des revendications 1 à 8, **caractérisée par** un dispositif d'entraînement de déplacement (30 ; 49 ; 52 ; 72) destiné à déplacer vers l'agencement de trame (12, 16) ladite au moins une unité de variation d'angle d'éclairage (14b ; 34b ; 45, 46 ; 51 ; 64, 65 ; 73, 74 ; 76, 77) pouvant être déplacée.

10. Optique d'éclairage selon l'une des revendications 1 à 9, **caractérisée par** un dispositif de mesure (32) destiné à mesurer un paramètre d'éclairage de la lumière d'éclairage (8) sur le champ d'éclairage (3).

11. Optique d'éclairage selon les revendications 9 et 10, **caractérisée en ce que** le dispositif de mesure (32) est en liaison de signal avec le dispositif d'entraînement de déplacement (30 ; 49 ; 52 ; 72) par l'intermédiaire d'une unité de commande/régulation (33).

12. Système optique comprenant une optique d'éclairage selon l'une des revendications 1 à 11 et comprenant une optique de projection (21) destinée à former l'image d'au moins une partie du champ d'éclairage (3) dans un champ d'image dans un plan d'image (22).

13. Système d'exposition par projection (1) comprenant

- un système optique selon la revendication 12,
- une source de lumière primaire (6),
- un porte-objet (24) doté d'un dispositif d'entraînement de déplacement d'objet (25) destiné à maintenir un objet (23) dans le champ d'éclairage (3),
- un porte-plaquette (26) comportant un dispositif d'entraînement de déplacement de plaquette (27) destiné à maintenir une plaquette (22a) dans le champ d'image.

14. Procédé de fabrication par microlithographie de composants microstructurés, comprenant les étapes suivantes :

- fourniture d'un substrat (22a) sur lequel est au moins partiellement appliquée une couche d'un matériau photosensible,
- fourniture d'un réticule (23) présentant des structures dont l'image doit être formée,
- fourniture d'un système d'exposition par projection (1) selon la revendication 13,
- projection d'au moins une partie du réticule (23) sur une zone de la couche à l'aide du système d'exposition par projection (1).

Fig. 1

EP 2 824 512 B1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

Fig. 20

Fig. 21

γ=0°

51
58
2

y=y'

x=x'

Fig. 22

γ=45°

58
51
2

y   y'

x

x'

Fig. 23

γ=90°

51
58
2

y

x=y'

x'

Fig. 24

Fig. 25

51  58  59  60  44  45a

2

61  58  8  62  45a

y

x

**Fig. 26**

45a  44  60  59  58  51

y

2

x

45a  8  62  58  61

**Fig. 27**

Fig. 28

Fig. 29

Fig. 30

Fig. 31

Fig. 32

Fig. 33

Fig. 34

Fig. 35

Fig. 36

Fig. 37

Fig. 38

Fig. 39

Fig. 40

Fig. 41

Fig. 42

Fig. 43

Fig. 44

Fig. 45

Fig. 46

Fig. 47

Fig. 48

105 107 109 108 106 104

Fig. 49

Fig. 50

Fig. 51

Fig. 52

110

112 112

Z

0

d

x

0

Fig. 53

d

x

0

Fig. 54

Fig. 55

Fig. 56

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2007093433 A1
- WO 2005083512 A2
- WO 2011157601 A2
- DE 102008040181 A1
- DE 102004063314 A1

- US 7414781 B
- WO 2009141033 A1
- EP 0851304 A
- DE 102005026628 A1
- DE 102007055096 A1